# EUROPEAN PATENT APPLICATION

(11) **EP 4 700 834 A1**
(43) Date of publication of application: **25.02.2026**
(21) Application number: 24793001.9
(22) Date of filing: 17.04.2024
(51) Int. Cl.: H01L 33/08, H01L 33/48, H01L 33/52, H01L 33/14, H01L 33/02, H01L 33/44, H01L 33/62, H01L 25/075

(54) **LIGHT-EMITTING MODULE COMPRISING LIGHT-EMITTING ELEMENT, AND DISPLAY DEVICE**

(30) Priority: 20.04.2023 US 202363497237 P; 19.05.2023 US 202363467633 P; 24.11.2023 US 202363602476 P; 16.01.2024 US 202463621342 P; 15.04.2024 US 202418635197
(71) Applicant: Seoul Viosys Co., Ltd., Ansan-si, Gyeonggi-do 15429 (KR)
(72) Inventor: CHA, Namgoo, Ansan-si Gyeonggi-do 15429 (KR); LEE, Sunghyun, Ansan-si Gyeonggi-do 15429 (KR); LEE, Chungjae, Ansan-si Gyeonggi-do 15429 (KR)
(74) Representative: Stolmár & Partner Patentanwälte PartG mbB
(86) International application number: PCT/KR2024/005153
(87) International publication number: WO 2024/219816

(57) **Abstract**

A display module according to an embodiment includes: a circuit board; a light emitting device disposed on the circuit board; and a molding layer covering the light emitting device, the light emitting device, including: a first LED stack generating light of a first wavelength; a second LED stack disposed on the first LED stack and generating light of a second wavelength; and a third LED stack disposed on the second LED stack and generating light of a third wavelength, in which each of the first, second, and third LED stacks includes a first conductivity type semiconductor layer, a second conductivity type semiconductor layer, and an active layer disposed between the first conductivity type semiconductor layer and the second conductivity type semiconductor layer, and polarities of the first LED stack and the third LED stack disposed over and under the second LED stack are asymmetric with respect to the second LED stack.

## Description

### [Technical Field]

The present disclosure relates to a light emitting device, a display module including the same, and a display apparatus including the same.

### [Background Art]

A light emitting device is a semiconductor device using a light emitting diode, which is an inorganic light source, and is widely used in various fields such as display apparatuses, vehicle lamps, general lighting, and others. The light emitting diode has advantages of long lifespan, low power consumption, and fast response speed, and thus, the light emitting diode has been rapidly replacing a conventional light source.

Conventional light emitting devices have been generally used as backlight light sources in display apparatuses, and display apparatuses that directly realize images using the light emitting devices have been recently developed. Such displays are also referred to as micro LED displays.

In general, the display apparatus displays various colors through mixture of blue, green, and red light. In order to realize various images, the display apparatus includes a plurality of pixels, each including sub-pixels corresponding to one of blue, green, and red light. As such, a color of a certain pixel is typically determined based on the colors of the sub-pixels, so that images can be realized through the combination of such pixels.

In the case of the micro LED display, micro LEDs corresponding to sub-pixels, respectively, are arranged on a plane, and numerous micro LEDs are mounted on a single substrate. However, since the micro LEDs are very small which are less than 200 µm and even less than 100 µm, it is quite difficult to transfer the micro LEDs to a circuit board. In addition, even after mounting a small-sized light emitting device on the circuit board, a technology which physically protects the light emitting device without optical distortion or luminance loss is also required

Meanwhile, to alleviate the difficulty of mounting the micro LEDs, stacked micro LEDs in which blue, green, and red LEDs are vertically stacked have been developed. Since the stacked micro LEDs are arranged in pixel units on a plane, the mounting processes can be simplified. However, the electrical connection structure becomes complicated as the sub-pixels are stacked, it is difficult to manufacture the stacked micro LEDs, and the performance and reliability of stacked micro LED devices are relatively low.

### [Disclosure]

### [Technical Problem]

Exemplary embodiments of the present disclosure provide a light emitting device with a novel structure that is configured to improve a performance and reliability of a light emitting device having a stacked structure for a micro LED display, a display module including the same, and a display apparatus including the same.

### [Technical Solution]

A display module according to an embodiment of the present disclosure includes: a circuit board; a light emitting device disposed on the circuit board; and a molding layer covering the light emitting device, the light emitting device, including: a first LED stack generating light of a first wavelength; a second LED stack disposed on the first LED stack and generating light of a second wavelength; and a third LED stack disposed on the second LED stack and generating light of a third wavelength, in which each of the first, second, and third LED stacks includes a first conductivity type semiconductor layer, a second conductivity type semiconductor layer, and an active layer disposed between the first conductivity type semiconductor layer and the second conductivity type semiconductor layer, and polarities of the first LED stack and the third LED stack disposed over and under the second LED stack are asymmetric with respect to the second LED stack.

Among the first and second conductivity type semiconductor layers of each of the first through third LED stacks, a polarity of a semiconductor layer disposed closer to the circuit board may be a p-type.

Among the first and second conductivity type semiconductor layers of each of the first through third LED stacks, a thickness of the semiconductor layer disposed closer to the circuit board may be smaller than that of the semiconductor layer disposed farther from the circuit board.

The first and second conductivity type semiconductor layers of each of the first through third LED stacks may include different types of first and second impurities, respectively, and an impurity that provides a carrier with slow mobility among the first and second impurities may be disposed closer to the circuit board.

Each of the first conductivity type semiconductor layers of the first through third LED stacks may include contact layers in contact with electrodes, and the contact layers may have different doping concentrations from one another.

Among the first and second conductivity type semiconductor layers of each of the first through third LED stacks, the semiconductor layer closer to the circuit board may include a layer having a highest band gap energy.

In each of the first through third LED stacks, the active layer may be disposed closer to the circuit board from a center of a corresponding LED stack.

Each of the first through third LED stacks has a lower surface on a circuit board side, and distances from the lower surfaces of each of the first through third LED stacks to each active layer may be different from one another.

Each of the first through third LED stacks has an upper surface on an opposite side of the circuit board, and distances from the upper surfaces of each of the first through third LED stacks to each active layer may be different from one another.

In each of the first through third LED stacks, the first conductivity type semiconductor layer may be disposed closer to the outside of the display module than the second conductivity type semiconductor layer.

Semiconductor layers facing each other of the first LED stack and the second LED stack may have different polarities from each other.

Semiconductor layers facing each other of the second LED stack and the third LED stack may have different polarities from each other.

A vertical light path for light generated in the active layer of the first LED stack to escape the first LED stack may be longer in an upper portion facing an opposite direction of the circuit board than in a lower portion facing the circuit board.

A vertical light path for light generated in the active layer of the second LED stack to escape the second LED stack may be longer in an upper portion facing the opposite direction of the circuit board than in a lower portion facing the circuit board.

A vertical light path for light generated in the active layer of the third LED stack to escape the third LED stack may be longer in an upper portion facing the opposite direction of the circuit board than in a lower portion facing the circuit board.

The light emitting device may further include: a first insulation layer disposed on the first through third LED stacks; a protection layer covering the first insulation layer; and electrode pads disposed on the protection layer, in which the first insulation layer may have contact holes for allowing electrical connection to the first through third LED stacks, the protection layer may include through-holes for allowing electrical connection to the first through third LED stacks, and the electrode pads may be electrically connected to the first through third LED stacks through the through-holes of the protection layer and the contact holes of the first insulation layer.

At least one of the electrode pads may include a depression portion in the contact hole of the first insulation layer.

At least one of the through-holes of the protection layer may have an asymmetric structure with respect to a line passing through a center of the through-hole.

The through-holes may have an inner surface close to a center of the light emitting device and an outer surface close to the outside of the light emitting device, and slopes of the inner surface and the outer surface may be different from each other.

A height of a highest point of the inner surface may be different from that of a highest point of the outer surface.

A curvature of the inner surface may be different from that of the outer surface.

A second contact electrode contacting the second conductivity type semiconductor layer of the second LED stack and a bridge electrode disposed on the second contact electrode may be further included, in which one of the electrode pads may be electrically connected to the bridge electrode.

The first conductivity type semiconductor layer of the second LED stack may be disposed between the first conductivity type semiconductor layer of the first LED stack and the second conductivity type semiconductor layer of the second LED stack, the second contact electrode may have an extension portion protruding outward from an outer surface of the second LED stack, and the bridge electrode may be disposed on the extension portion.

A first ohmic electrode formed on the first conductivity type semiconductor layer of the first LED stack may be further included, in which the bridge electrode may include at least one material different from that of the first ohmic electrode.

The bridge electrode may have a thermal expansion coefficient different from that of the first ohmic electrode.

The bridge electrode may have a thermal conductivity different from that of the first ohmic electrode.

The bridge electrode may have a thickness different from that of the second contact electrode.

The first insulation layer may have a contact hole exposing the bridge electrode, and a height of a bottom surface of the contact hole may be same as a height of an upper surface of the bridge electrode.

A side surface of the second LED stack facing a side surface of the bridge electrode may be inclined.

The bridge electrode may include a plurality of metallic layers.

The upper surface of the bridge electrode may include regions with different morphologies from one another.

An upper surface of a region of the bridge electrode to which the electrode pad is connected may have a more uneven morphology than an upper surface of a neighboring region of the bridge electrode.

At least one end of the bridge electrode may include a bent portion.

### [Brief Description of Drawings]

FIG. 1A is a schematic plan view illustrating a light emitting device according to an embodiment of the present disclosure.
FIG. 1B is a schematic cross-sectional view taken along line A-A' of FIG. 1A.
FIG. 1C is a schematic cross-sectional view taken along line B-B' in FIG. 1A.
FIG. 1D is a SEM image illustrating a circular dotted line portion of FIG. 1C.
FIGs. 2A, 2B, and 2C are schematic cross-sectional views illustrating steps of providing a first LED stack according to an embodiment of the present disclosure.
FIG. 3 is a schematic cross-sectional view illustrating a step of providing a second LED stack according to an embodiment of the present disclosure.
FIG. 4 is a schematic cross-sectional view illustrating a step of providing a third LED stack according to an embodiment of the present disclosure.
FIG. 5A is a schematic cross-sectional view illustrating a process of bonding the second LED stack to the third LED stack according to an embodiment of the present disclosure.
FIG. 5B is a schematic cross-sectional view illustrating a process of bonding the first LED stack to the second LED stack according to an embodiment of the present disclosure.
FIGs. 6A, 7A, 8A, and 9A are schematic plan views illustrating a method of manufacturing a light emitting device according to an embodiment of the present disclosure.
FIGs. 6B, 7B, 8B, and 9B are schematic cross-sectional views taken along line A-A' of FIGs. 6A, 7A, 8A, and 9A.
FIGs. 6C, 7C, 8C, and 9C are schematic cross-sectional views taken along line B-B' of FIGs. 6A, 7A, 8A, and 9A.
FIGs. 10A and 10B are schematic cross-sectional views illustrating a light emitting device according to another embodiment of the present disclosure.
FIGs. 11A and 11B are schematic cross-sectional views illustrating a light emitting device according to another embodiment of the present disclosure.
FIG. 12 is a schematic cross-sectional view illustrating a light emitting module according to an embodiment of the present disclosure.
FIG. 13 is a schematic cross-sectional view illustrating a light emitting device according to another embodiment of the present disclosure.
FIG. 14 is a SEM image illustrating a bridge electrode formed on a second contact electrode.
FIG. 15 is a SEM image illustrating a bridge electrode of another embodiment.
FIGs. 16A and 16B are schematic cross-sectional views illustrating a light emitting device according to another embodiment of the present disclosure.
FIG. 17 is a schematic cross-sectional view enlarging a circular dotted line portion of FIG. 16A.
FIG. 18 is a schematic plan view illustrating a display apparatus according to an embodiment.
FIG. 19 is a schematic perspective view illustrating various display apparatuses according to an exemplary embodiment.
FIG. 20 is a schematic perspective view illustrating another display apparatus according to an exemplary embodiment.
FIG. 21 is a schematic perspective view illustrating another display apparatus according to an embodiment.

### [Detailed Description of Embodiments]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

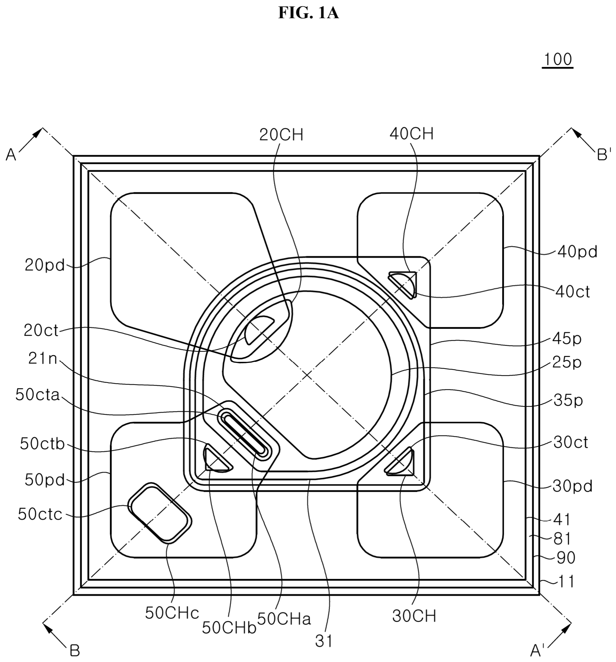

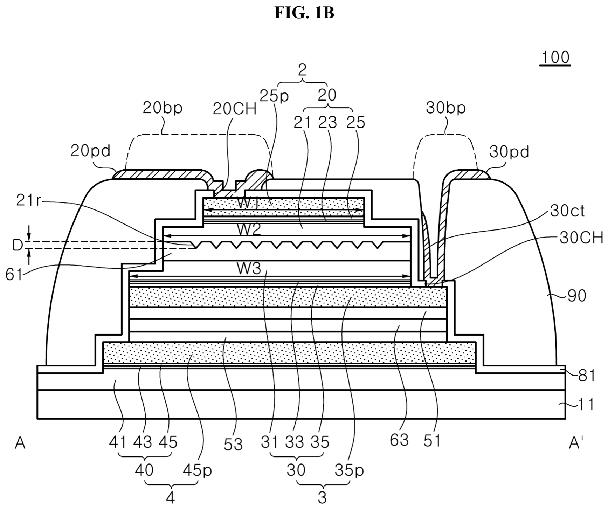

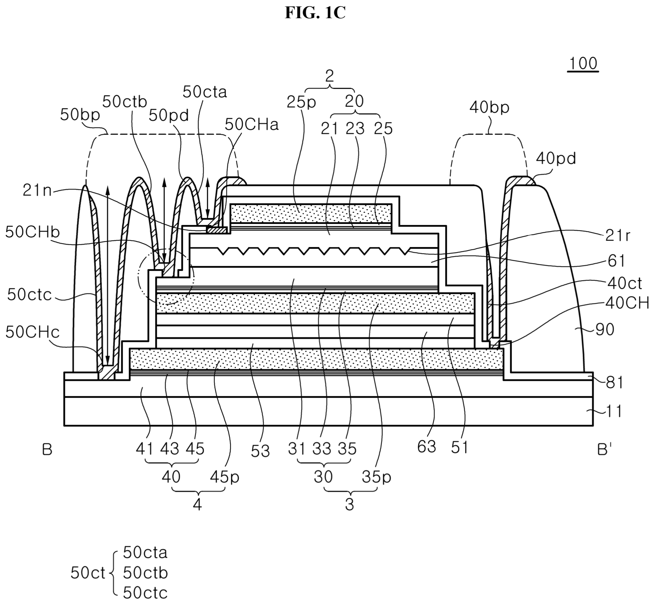

FIGs. 1A, 1B, and 1C are a schematic plan view and cross-sectional views illustrating a light emitting device 100 according to an embodiment of the present disclosure.

Referring to FIGs. 1A to 1C, the light emitting device 100 may include a substrate 11 and first, second, and third subunits 2, 3, and 4, and further, may include a first adhesive layer 61, a second adhesive layer 63, first and second stress relief layers 51 and 53, a first insulation layer 81, a protection layer 90, and first through fourth electrode pads 20pd, 30pd, and 40pd, and 50pd. The light emitting device 100 shown in FIG. 1A may be formed by singularizing a plurality of light emitting device arrays formed on the substrate 11. The light emitting device 100 including the first, second, and third subunits 2, 3, and 4 may be mounted on a circuit board to form a light emitting module, for example, a display module, which will be described in detail later.

The substrate 11 may include a light-transmitting insulating material to transmit light. However, the inventive concepts are not limited thereto, and the substrate 11 may be formed to be translucent or partially transparent to transmit only light of a specific wavelength or only a portion of light of a specific wavelength. The substrate 11 may be a growth substrate capable of epitaxially growing a third LED stack 40, for example, a sapphire substrate. However, the substrate 11 is not limited to the sapphire substrate, and may include various other light-transmitting insulating materials. The substrate 11 may include glass, quartz, silicon, organic polymers, organic-inorganic composite materials, or the like, and for example, may include silicon carbide (SiC), gallium nitride (GaN), indium gallium nitride (InGaN), aluminum gallium nitride (AlGaN), aluminum nitride (AlN), gallium oxide (Ga₂O₃), or a silicon substrate.

An area of the substrate 11 may define an area of the light emitting device 100. In an embodiment, the area of the substrate 11 may be formed to be same as that of the third subunit 4. The area of the substrate 11 may be about 60,000µm² or less, and further, 30,000µm² or less, furthermore 10,000µm² or less. The substrate 11 may have a thickness of 30µm to 180µm, specifically, 30µm to 100µm. In an embodiment, the substrate 11 may have an area of 225µm × 225µm and a thickness of 50µm. As a ratio of thickness to area of the substrate 11 decreases, for a total light amount extracted to the outside, it is possible to reduce a ratio of a light amount extracted in a direction parallel to a rear surface of the substrate 11, that is, a side surface, and it is possible to increase a ratio of a light amount transmitted in a direction perpendicular to the rear surface of the substrate 11 and extracted. In particular, by reducing the thickness of the substrate 11, light emitted from the third subunit 4 adjacent to the substrate 11 may be better emitted in the direction perpendicular to the rear surface of the substrate 11. Accordingly, a color difference according to a viewing angle may be alleviated by reducing a deviation of light extracted from the light emitting device 100.

The light emitting device 100 may include the first subunit 2, the second subunit 3, and the third subunit 4 on the substrate 11 as shown in FIG. 1B. According to an embodiment, the first, second, and third subunits 2, 3, and 4 may emit light of different peak wavelengths from one another. In detail, light emitted from the first subunit 2 may pass through the second and third subunits 3 and 4. In an embodiment, a subunit farther from the substrate 11 emits light of a wavelength longer than that of a subunit closer to the substrate 11, thereby reducing light loss. For example, the first subunit 2 may emit light of a wavelength longer than those of the second and third subunits 3 and 4, and the second subunit 3 may emit light of a wavelength longer than those of the second and third subunits 3 and 4. For example, the first subunit 2 may emit red light, the second subunit 3 may emit green light, and the third subunit 4 may emit blue light.

In another embodiment, to adjust a color mixing ratio of the first, second, and third subunits 2, 3 and 4, the second subunit 3 may emit light of a wavelength shorter than that of the third subunit 4. Accordingly, a luminous intensity of the second subunit 3 may be reduced, a luminous intensity of the third subunit 4 may be increased, and a luminous intensity ratio of light emitted from the first, second, and third subunits 2, 3, and 4 may be controlled. For example, the light emitting device may be configured such that the first subunit 2 emits red light, the second subunit 3 emits blue light, and the third subunit 4 emits green light. Accordingly, a luminous intensity of blue light may be relatively reduced and a luminous intensity of green light may be relatively increased, and thus, a luminous intensity ratio of red, green, and blue may be adjusted to approach 3:6:1. In addition, light emitting areas of the first, second, and third subunits 2, 3 and 4 may 10,000µm² or less, specifically 4,000µm² or less, more specifically 2,500µm² or less. In addition, the light emitting area of a subunit may be larger as the subunit is closer to the substrate 11, and the luminous intensity of green light may be further increased by arranging the third subunit 4 emitting green light closest to the substrate 11. Although the light emitting device 100 is illustrated as including three subunits 2, 3 and 4, but the inventive concepts are not limited to a specific number of subunits. For example, the light emitting device may include two or more subunits in some embodiments. Herein, the light emitting device 100 including three subunits 2, 3, and 4 according to an embodiment will be exemplarily described.

In the following description, the second subunit 3 emitting light of a wavelength shorter than that of the third subunit 4, for example, blue light, will be exemplarily described, but it should be noted that the second subunit 3 may emit light of a wavelength longer than that of the third subunit 4, for example, green light.

The first subunit 2 may include a first LED stack 20 and a first contact electrode 25p, and further, may include a first ohmic electrode 21n.

The first LED stack 20 may include a first conductivity type semiconductor layer 21, an active layer 23, and a second conductivity type semiconductor layer 25. According to an embodiment, the first LED stack 20 may include a semiconductor material emitting red light, such as AlGaAs, GaAsP, AlGaInP, and GaP, without being limited thereto.

The first contact electrode 25p is in ohmic contact with the second conductivity type semiconductor layer 25. The first contact electrode 25p may be formed of a light-transmitting conductive oxide such as indium tin oxide (ITO), without being limited thereto, and for example, it may be formed of a metallic layer capable of being in ohmic contact with the second conductivity type semiconductor layer 25. The first contact electrode 25p may be formed of, for example, ITO with a thickness of 100 nm to 400 nm.

The first ohmic electrode 21n may be disposed on the first conductivity type semiconductor layer 21, and may form an ohmic contact with the first conductivity type semiconductor layer 21. The first contact electrode 25p, the active layer 23, and the second conductivity type semiconductor layer 25 may be patterned, and thus, an upper surface of the first conductivity type semiconductor layer 21 may be exposed. The first ohmic electrode 21n may be formed on the exposed first conductivity type semiconductor layer 21.

The first ohmic electrode 21n may have a single-layer structure or a multi-layer structure, and may include Al, Ti, Cr, Ni, Au, Ag, Sn, W, Cu or an alloy thereof, for example, an Au-Te alloy or Au-Ge alloy, without being limited thereto.

In this embodiment, the first conductivity type semiconductor layer 21 may be disposed closer to the second subunit 3 and the third subunit 4 than the second conductivity type semiconductor layer 25. Light generated in the active layer 23 may be emitted toward the second subunit 3 and the third subunit 4 through the first conductivity type semiconductor layer 21.

In this embodiment, the first conductivity type semiconductor layer 21 may include a roughened surface 21r, and an extraction efficiency of light generated in the active layer 23 may be increased by the roughened surface 21r. A depth D of a concave portion of the roughened surface 21r may be in a range of about 0.1 µm to 0.9 µm. The roughened surface 21r may be disposed toward the second subunit 3, and the third subunit 4 and may be in contact with the adhesive 61. The roughened surface 21r may be formed through wet or dry etching, and a side inclination angle of a protrusion portion or the concave portion may be in a range of 35 degrees to 65 degrees. The roughened surface 21r may be a micro-optic. Accordingly, when light generated in the first subunit 2 is directed to the second subunit 3, it may be focused upward by the micro-optic. The micro-optic may have an irregular shape, or may have a regular shape. The adhesive 61 may be filled in a depth region of the micro-optic. The adhesive 61 may have a refractive index different from that of the micro-optic. Accordingly, the light extraction efficiency may be improved by increasing a surface area where the micro-optic is in contact with a material having a different refractive index. In addition, as the adhesive fills the depth region of the micro-optic, regions of different heights are also generated in the adhesive. Accordingly, since the adhesive also serves as the micro-optic, it may be effective in light extraction. Materials of an upper surface and a lower surface of an interface of the micro-optic may be different from each other, and may have different refractive indices from each other. That is, the interface of the micro-optic may be disposed to be buried by the materials disposed on upper and lower portions.

In cross section view, a width W2 of a region where the micro-optic is formed may be larger than a width W1 of the first contact electrode 25p. In this case, the region where the micro-optic is formed includes a plurality of concavo-convex portions. In addition, the width W2 of the region where the micro-optic is formed may be smaller than a maximum width W3 of a second LED stack 30. Accordingly, light emitted through the micro-optic may be made to be incident toward the second LED stack 30 as much as possible.

In addition, the first insulation layer 81 may include a distributed Bragg reflector (DBR), and by using the first insulation layer 81 to reflect light generated in the active layer 23, a luminance of light emission of the subunit 2 may be increased. The DBR of the first insulation layer 81 may be formed to have a high reflectance of about 80% or more for light in a wavelength range of 400 nm to 700 nm.

The DBR of the first insulation layer 81 may have a thickness in a range of 500 nm to 3000 nm. When the thickness is smaller than 500 nm, it becomes difficult to achieve high reflectance over a wide wavelength. In addition, when the DBR of the first insulation layer 81 becomes thicker than 3000 nm, a possibility of cracks occurring in the first insulation layer 81 increases due to various inclination angles of a surface on which the DBR is formed. However, the inventive concepts are not limited thereto. For example, in an embodiment, the first insulation layer 81 may include a crack formed by a stepped region, and the crack formed in the first insulation layer 81 may be filled with the protection layer 90. Accordingly, even when the crack is formed in the first insulation layer 81, the crack is filled with the protection layer 90, and thus, the electrode pads 20pd, 30pd, 40pd, and 50pd formed thereon may be formed on a smooth surface.

The second subunit 3 may include the second LED stack 30 and a second lower contact electrode 35p.

The second LED stack 30 may include a first conductivity type semiconductor layer 31, an active layer 33, and a second conductivity type semiconductor layer 35. In an embodiment, the second LED stack 30 may include a semiconductor material emitting blue light, such as GaN, InGaN, ZnSe, and the like, without being limited thereto. The second contact electrode 35p may be disposed on the second conductivity type semiconductor layer 35 of the second LED stack 30, and may be in ohmic contact with the second conductivity type semiconductor layer 35. For electrical connection, the second contact electrode 35p may protrude outward from a second LED stack 30 region. The second electrode pad 30pd, which will be described later, is connected to a protruding region of the second contact electrode 35p. The second contact electrode 35p may be formed of a material that is transparent to light generated in the first subunit 2 and the third subunit 4, for example, red light and blue light, and it may be formed of, for example, light-transmitting conductive oxide, such as ITO or ZnO. The second contact electrode 35p may be formed of, for example, ITO with a thickness of 200 nm to 400 nm.

In this embodiment, the first conductivity type semiconductor layer 31 of the second LED stack 30 may be disposed to face the first conductivity type semiconductor layer 21 of the first LED stack 20. An upper surface of the first conductivity type semiconductor layer 31 may be exposed, and the first electrode pad 50pd, which will be described later, may be electrically connected to an exposed surface of the first conductivity type semiconductor layer 31.

The third subunit 4 may include the third LED stack 40 and a third contact electrode 45p.

The third LED stack 40 may include a first conductivity type semiconductor layer 41, an active layer 43, and a second conductivity type semiconductor layer 45. In an embodiment, the third LED stack 40 may include a semiconductor material emitting green light, such as GaN, InGaN, GaP, AlGaInP, AlGaP, or the like. The third contact electrode 45p may be disposed on the second conductivity type semiconductor layer 45 of the third LED stack 40, and may be in ohmic contact with the second conductivity type semiconductor layer 45. The third contact electrode 45p may be formed of a material that is transparent to light generated in the first subunit 2 and the third subunit 4, for example, red light and blue light, and it may be formed of, for example, light-transmitting conductive oxide, such as ITO or ZnO. The third upper contact electrode 45p may be formed of, for example, ITO with a thickness of 200 nm to 400 nm.

In this embodiment, the second conductivity type semiconductor layer 45 of the third LED stack 40 faces the second conductivity type semiconductor layer 35 of the second LED stack 30. That is, the second LED stack 30 and the third LED stack 40 are disposed such that the second conductivity type semiconductor layers 35 and 45 of a same polarity face each other. The second LED stack 30 and the first LED stack 20 are also disposed such that the first conductivity type semiconductor layers 21 and 31 of a same polarity face each other.

In the embodiments of the present disclosure, each of the first conductivity type semiconductor layers 21, 31, and 41 and the second conductivity type semiconductor layers 25, 35, and 45 of the first, second, and third LED stacks 20, 30, and 40 may have a single-layer structure or a multi-layer structure, and may also include a superlattice layer. In addition, the active layers 23, 33, and 43 of the first, second, and third LED stacks 20, 30, and 40 may have a single quantum well structure or a multiple quantum well structure.

A total thickness from the first subunit 2 to the third subunit 4 including the first, second, and third LED stacks 20, 30, and 40 may be, for example, about 10 µm to about 30 µm. In a case of the light emitting device 100 further including the substrate 11, the substrate 11 may be thicker than the total thickness of the first, second, and third subunits 2, 3, and 4. In an embodiment, a ratio of the thickness of the substrate 11 to the thickness of the first, second and third subunits 2, 3, and 4 may be in a range of 1.5:1 to 6:1, further, 1.5:1 to 4:1, and furthermore, 2.27:1 to 2.78:1. As the thickness ratio decreases, that is, the thickness of the substrate 11 relative to the thickness of the first, second, and third subunits 2, 3, and 4 decreases, with respect to light emitted to the outside of the light emitting device 100, a proportion of light extracted from a side surface of the substrate 11 decreases, and a proportion of light extracted through the substrate 11 in a direction perpendicular to a rear surface of the substrate 11 increases. Accordingly, a difference in radiation patterns of light extracted from the light emitting device 100 may be reduced, thereby alleviating color differences depending on viewing angles.

The thickness of the substrate 11 may be greater than the thickness including the first, second, and third LED stacks 20, 30, and 40. Alternatively, it may be arranged to vertically overlap with the pad electrodes 20pd, 30pd, 40pd, and 50pd and the first, second, and third LED stacks 20, 30, and 40. In addition, it may be greater than a thickness of the protection layer 90. Through this, effective improvement on a light deviation due to the viewing angles is possible.

Each of the first contact electrode 25p, the second contact electrode 35p, and the third contact electrodes 45p may include a light-transmitting conductive material that transmits light. For example, the contact electrodes 25p, 35p, and 45p may be transparent conductive oxide (TCO), and the transparent conductive oxide (TCO) may include SnO, InO2, ZnO, ITO, ITZO, and the like, but the inventive concepts are not limited thereto.

The first adhesive layer 61 may be disposed between the first LED stack 20 and the second LED stack 30, and the second adhesive layer 63 may be disposed between the second LED stack 30 and the third LED stack 40. The first adhesive layer 61 may be in contact with the first conductivity type semiconductor layer 21 of the first LED stack 20 and the first conductivity type semiconductor layer 31 of the second LED stack 30. The first adhesive layer 61 may include regions with different thicknesses from each other, that is, a thick region and a thin region. Alternatively, a thickness of the second adhesive layer 63 may be smaller than a maximum thickness of the thick region and greater than a minimum thickness of the thin region of the first adhesive layer 61. For example, the second adhesive layer 63 may be formed to have a thickness within a range of 1.8 µm to 2.2 µm. The first and second adhesive layers 61 and 63 may include a non-conductive material that transmits light. For example, the first and second adhesive layers 61 and 63 may include an optically clear adhesive (OCA), such as epoxy, silicone, polyimide, SU8, spin-on-glass (SOG), and benzocyclobutene (BCB), but the inventive concepts are not limited thereto. The first adhesive layer 61 and the second adhesive layer 63 do not need to be identical to each other, and may be formed of different materials, for example, materials with different refractive indices, melting points, or transmittances from each other.

The first stress relief layer 51 may be disposed on one surface of the second adhesive layer 63, and may be disposed between the second adhesive layer 63 and the second LED stack 30. The second stress relief layer 53 may be disposed on the other surface of the second adhesive layer 63, and disposed between the second adhesive layer 63 and the third LED stack 40. Each of the first and second stress relief layers 51 and 53 may be formed to have a thickness of, for example, 50 nm to 150 nm. The first and second stress relief layers 51 and 53 may include an insulating material. For example, the first and second stress relief layers 51 and 53 may include an organic or inorganic insulating material, such as polyimide, SiO₂, SiNx, Al₂O₃, and the like, for example, SiO₂, but the inventive concepts are not limited thereto. The second stress relief layer 53 may be omitted.

The first and second stress relief layers 51 and 53 may be disposed between the LED stacks, when the first, second, and third LED stacks 20, 30 and 40 are arranged to vertically overlap with one another. In more detail, in a course of sequentially bonding the second LED stack 30 and the first LED stack 20 on the third LED stack 40, warpage of the LED stacks or the substrate 11 may occur, and due to this, a crack may occur between the LED stacks 20, 30, and 40. The first and second stress relief layers 51 and 53 disposed between the LED stacks 20, 30, and 40 may alleviate the warpage that may occur in the course, and accordingly, defects such as cracks may occur between the LED stacks 20, 30, and 40 may be prevented.

The first insulation layer 81 may be disposed on at least portions of upper and side surfaces of the first, second, and third LED stacks 20, 30, and 40. The first insulation layers 81 may include various organic or inorganic insulating materials, such as polyimide, TiO₂, SiO₂, Nb₂O₅, SiNx, Al₂O₃, and the like. In addition, the first insulation layer 81 may include a single-layer structure or a multi-layer structure, and an example of the multi-layer structure may include a distributed Bragg reflector (DBR). In an embodiment, the first insulation layer 81 may be formed as a distributed Bragg reflector (DBR). A thickness of the first insulation layer 81 may be about 500 nm to 3000 nm.

Although not shown in the drawings, a sub-insulation layer having a thickness smaller than that of the first insulation layer 81 may be further disposed under the first insulation layer 81, and the sub-insulation layer may be a SiO₂ layer. The sub-insulation layer may have the thickness of 50% or less of the thickness of the first insulation layer 81.

The distributed Bragg reflector (DBR) of the first insulation layer 81 may include a first material layer having a first refractive index and a second material layer having a second refractive index. The first material layer may have a lower refractive index, and the second material layer may have a higher refractive index. The "lower refractive index" and the "higher refractive index" refer to a relative difference in refractive indices comparing those of the first material layer and the second material layer. In an embodiment, the first material layers may be SiO₂, and the second material layers may be TiO₂. However, in the present disclosure, the first material layer and the second material layer are limited to SiO₂ and TiO₂, and for example, the first and second material layers may be formed of Si₃N₄, MgF₂, Nb₂O₅, ZnS, ZrO₂, ZnO, a compound semiconductor, or the like. However, the difference in refractive indices between the first material layer and the second material layer may be greater than 0.5.

The distributed Bragg reflector (DBR) may be formed by repeatedly stacking pairs of the first material layers and the second material layers multiple times. A material layer with a higher refractive index may have a higher absorption rate than that of a material layer with a lower refractive index. Therefore, loss due to light absorption may be reduced by making optical thicknesses of the second material layers with the higher refractive index smaller than that of the first material layers with the lower refractive index. Each thickness of SiO₂, which is the first material layer, may be formed thicker than each thickness of TiO₂, which is the second material layer.

The first material layers forming the distributed Bragg reflector (DBR) may be formed such that at least two layers have different thicknesses. Alternatively, the second material layers forming the distributed Bragg reflector (DBR) may be formed such that at least two layers have different thicknesses. Since the distributed Bragg reflector (DBR) has to function optically for different peak wavelengths of light generated in each of the LED stacks 20, 30, and 40, at least two layers of the first material layers or the second material layers are made to be formed with different thicknesses, and thus, optical functions such as light reflection or light path change for a plurality of peak wavelengths may be improved.

In addition, a first layer and a last layer of the distributed Bragg reflector (DBR) may be SiO₂. By using the SiO₂ as the first layer of the distributed Bragg reflector (DBR), an adhesion with the first insulation layer 81 may be enhanced, and by using the SiO₂ as the last layer, the distributed Bragg reflector (DBR) may be protected, and an adhesion of the protection layer 90 and the pad electrodes 20pd, 30pd, 40pd, and 50pd, which will be described later, may be enhanced.

The distributed Bragg reflector (DBR) may include, for example, 16 to 25 pairs of the first and second material layers, without being limited thereto. For example, the distributed Bragg reflector may have a thickness of 1.5 µm to 3 µm. The distributed Bragg reflector (DBR) may exhibit reflectivity of greater than 80% over a wavelength range of 400 nm to 700 nm.

As shown in FIGs. 1B and 1C, the first insulation layer 81 may be formed to extend to an upper surface of the first conductivity type semiconductor layer 41 of the third LED stack 40. In this embodiment, a side surface of the substrate 11 may be in flush with a side surface of the first conductivity type semiconductor layer 41, and a side surface of the first insulation layer 81 may also be in flush with the side surface of the substrate 11. In another embodiment, the side surface of the first conductivity type semiconductor layer 41 may be disposed inside a region surrounded by an edge of the substrate 11, and accordingly, an upper surface of the substrate 11 may be exposed outside of the first conductivity type semiconductor layer 41. In this case, the first insulation layer 81 may cover the side surface of the first conductivity type semiconductor layer 41 to extend to the upper surface of the substrate 11. Accordingly, a portion of the first insulation layer 81 may be in contact with the upper surface of the substrate 11. In addition, an outer side surface of the first insulation layer 81 may be disposed inside of an outer boundary of the first conductivity type semiconductor layer 41 of the third LED stack 40. Alternatively, the outer side surface of the first insulation layer 81 may be disposed inside of the outer boundary of the substrate 11. Therefore, the first insulation layer 81 may be formed to increase a region that reflects light, and to effectively block light that enters adjacent pixels.

The first insulation layer 81 may be etched to form contact holes 20CH, 30CH, 40CH, and 50CH, which will be described later. Accordingly, the contact electrodes 25p, 35p, and 45p may be electrically connected to the first, second, and third subunits 2, 3, and 4, respectively. In addition, the distributed Bragg reflector (DBR) of the first insulation layer 81 may cause a diffuse reflection of light extracted from the side surfaces of the first, second, and third subunits 2, 3, and 4, thereby improving light extraction efficiency.

When the first insulation layer 81 is formed of a dielectric layer having a low refractive index such as SiO₂, the first insulation layer 81 may form an omni-directional reflector together with the first through third LED stacks 20, 30, and 40 and the electrode pads 20pd, 30pc, 40pd, and 50pd covering the first insulation layer 81.

The protection layer 90 may be disposed on the first insulation layer 81. The protection layer 90 may include epoxy molding compound (EMC), without being limited to. For example, the protection layer 90 may be formed of a photosensitive polyimide dry film (PID). The protection layer 90 may be transparent, or have various colors such as black, white, or others, and may prevent light from leaking to a side surface of the light emitting device 100 to prevent or suppress interference of light emitted from an adjacent light emitting device 100.

The protection layer 90 may include through-holes 20ct, 30ct, 40ct, 50cta, 50ctb, and 50ctc corresponding to contact holes 20CH, 30CH, 40CH, 50CHa, 50CHb, and 50Chc. An outermost edge of the protection layer 90 may be disposed inside of the region surrounded by the edge of the substrate 11. However, the inventive concepts are not limited thereto, and the outermost edge of the protection layer 90 may be in flush with the edge of the substrate 11.

Each of the first, second, and third LED stacks 20, 30, and 40 may be driven independently. In an embodiment, a common voltage may be applied to the first conductivity type semiconductor layers 21, 31, and 41 of the first, second, and third LED stacks 20, 30, and 40, and an individual emission signal may be applied to each of the second conductivity type semiconductor layers 25, 35, and 45. In another embodiment, an individual light emission signal may be applied to each of the first conductivity type semiconductor layers 21, 31, and 41 of the first, second, and third LED stacks 20, 30, and 40, and a common voltage may be applied to the second conductivity type semiconductor layers 25, 35, and 45. For example, the first conductivity type semiconductor layers 21, 31, and 41 of each of the LED stacks 20, 30, and 40 may be an n-type, and the second conductivity type semiconductor layers 25, 35, and 45 may be a p-type. In this case, a common voltage may be applied to the first conductivity type semiconductor layers 21, 31, and 41, and an individual emission signal may be applied to each of the second conductivity type semiconductor layers 25, 35, and 45, or vice versa. When the first, second, and third LED stacks 20, 30, and 40 are vertically stacked, the third LED stack 40 may have an opposite stacking sequence compared to those of the first and second LED stacks 20 and 30. That is, the second conductivity type semiconductor layer 45 of the third LED stack 40, for example, a p-type semiconductor layer 45 may be disposed over the active layer 43, and the second conductivity type semiconductor layer 35 of the second LED stack 30 may be disposed under the active layer 33. A manufacturing process of the light emitting device 100 may be simplified by making the stacking sequence of the third LED stack 40 opposite to that of the second LED stack 30. In this embodiment, it has been described that the first conductivity type semiconductor layer and the second conductivity type semiconductor layer are the n-type and the p-type, respectively, but inventive concepts are not limited thereto, or vice versa.

According to the illustrated embodiment, the light emitting device 100 may include the first electrode pad 20pd, the second electrode pad 30pd, the third electrode pad 40pd, and the fourth electrode pad 50pd. The second conductivity type semiconductor layers 25, 35, and 45 of the LED stacks 20, 30, and 40 may be respectively connected to the first electrode pad 20pd, the second electrode pad 30pd, and the third electrode pad 40pd to receive a corresponding light emission signal, respectively. Meanwhile, the first conductivity type semiconductor layers 21, 31, and 41 of the LED stacks 20, 30, and 40 may be connected to the fourth pad electrode 50pd to receive a common voltage from the outside. In this way, each of the first, second, and third LED stacks 20, 30, and 40 may be driven independently while having a common n-type electrode to which a common voltage is applied, but the inventive concepts are not limited thereto.

The first through fourth electrode pads 20pd, 30pd, 40pd, and 50pd may have different regions from one another in plan view. Alternatively, at least two electrode pads among the first through fourth electrode pads 20pd, 30pd, 40pd, and 50pd may have different shapes from one another.

The first electrode pad 20pd may be connected to the first upper contact electrode 25p through a first contact hole 20CH defined through the first insulation layer 81, and in addition, may be electrically connected to the second conductivity type semiconductor layer 25.

The second electrode pad 30pd may be connected to the second lower contact electrode 35p through a second contact hole 30CH defined through the first insulation layer 81, and in addition, may be electrically connected to the second conductivity type semiconductor layer 35.

The third electrode pad 40pd may be connected to the third upper contact electrode 45p through a third contact hole 40CH defined through the first insulation layer 81, and in addition, may be electrically connected to the second conductivity type semiconductor layer 45.

The fourth electrode pad 50pd is commonly electrically connected to the first conductivity type semiconductor layers 21, 31, and 41 of the first, second, and third LED stacks 20, 30, and 40. For example, the fourth electrode pad 50pd may be electrically connected to a first lower contact electrode 21n, a second upper contact electrode 31n, and a third lower contact electrode 41n disposed on the first conductivity type semiconductor layers 21, 31, and 41 of the first, second, and third LED stacks 20, 30, and 40 through a first sub-contact hole 50CHa, a second sub-contact hole 50CHb, and a third sub-contact hole 50CHc defined through the first insulation layer 81. At least one of the first lower contact electrode 21n, the second upper contact electrode 31n, the third lower contact electrode 41n may be omitted, and the fourth electrode pad 50pd may be directly electrically connected to the first conductivity type semiconductor layer 21 of the first LED stack 20, and may be directly electrically connected to the first conductivity type semiconductor layer 31 of the second LED stack 30 through the second sub-contact hole 50CHb, or may be directly electrically connected to the first conductivity type semiconductor layer 41 of the third LED stack 40 through the third sub-contact hole 50CHc.

According to an embodiment, a side surface of the protection layer 90 may have an inclined surface, and the inclined surface may be linear or curved. The first electrode pad 20pd may be electrically connected to the first subunit 2 through a first through-hole 20ct defined through the protection layer 90. The first through-hole 20ct exposes at least a portion of the first contact hole 20CH of the first insulation layer 81. The second electrode pad 30pd may be electrically connected to the second subunit 3 through a second through-hole 30ct defined through the protection layer 90. The second through-hole 30ct exposes at least a portion of the second contact hole 30CH of the first insulation layer 81. The third electrode pad 40pd may be electrically connected to the third subunit 4 through a third through-hole 40ct defined through the protection layer 90. The third through-hole 40ct exposes at least a portion of the third contact hole 30CH of the first insulation layer 81. The fourth electrode pad 50pd pd may be electrically connected to the first through third subunits 2, 3, and 4 through fourth through-holes 50ct; 50cta, 50ctb, and 50ctc defined through the protection layer 90. The fourth through-hole 50ct may include first through third sub through-holes 50cta, 50ctb, and 50ctb, which expose at least portions of the first through third sub-contact holes 50CHa, 50CHb, and 50CHc, respectively.

The first electrode pad 20pd may extend from a portion in contact with the first contact electrode 25p and disposed on the inclined surface of the protection layer 90. In addition, the first electrode pad 20pd may extend from an inclined inner surface of the protection layer 90 to an upper surface of the protection layer 90, and may extend toward an outer side of the light emitting device 100.

A first bump 20bp may be disposed on an upper surface of the first electrode pad 20pd for electrical connection with the circuit board. The first electrode pad 20pd is disposed along a surface of the first through-hole 20ct disposed at the portion in contact with the first contact electrode 25p, and ensures a stable electrical connection between the light emitting device 100 and the circuit board. The first bump 20bp may fill the inside of the first through-hole 20ct. The first electrode pad 20pd may have a thickness smaller than that of the first bump 20bp.

The second electrode pad 30pd may extend from a portion in contact with the second contact electrode 35p and disposed on the inclined surface of the protection layer 90. Further, the second electrode pad 30pd may extend from the inclined surface of the protection layer 90 to the upper surface of the protection layer 90, and may extend toward the outer side of the light emitting device 100.

A second bump 30bp may be disposed on an upper surface of the second electrode pad 30pd for electrical connection with the circuit board. The second electrode pad 30pd is disposed along a surface of the second through-hole 30ct disposed at the portion in contact with the second contact electrode 35p, and ensures the stable electrical connection between the light emitting device 100 and the circuit board. A depth of the second through-hole 30ct filled with the second bump 30bp may be different from that of the first through-hole 20ct filled with the first bump 20bp, and the depth of the second through-hole 30ct filled with the second bump 30bp may be formed deeper. Therefore, the device may be robustly supported by filling the deep through-hole of the protection layer 90, which exposes a portion of the semiconductor layer for electrical connection, with a conductive material. The second electrode pad 30pd may have a thickness smaller than that of the second bump 30bp.

The third electrode pad 40pd may extend from a portion in contact with the third contact electrode 45p and disposed on the inclined surface of the protection layer 90. Further, the third electrode pad 40pd may extend from the inclined surface of the protection layer 90 to the upper surface of the protection layer 90, and may extend toward the outer side of the light emitting device 100.

A third bump 40bp may be disposed on an upper surface of the third electrode pad 40pd for electrical connection with the circuit board. The third electrode pad 40pd is disposed along a surface of the third through-hole 40ct at a portion in contact with the third contact electrode 45p, and the third bump 40bp fills the third through-hole 40ct and ensures the stable electrical connection between the light emitting device 100 and the circuit board. A depth of the third through-hole 40ct filled with the third bump 40bp may be different from that of the second through-hole 30ct filled with the second bump 30bp, and the depth of the third through-hole 40ct may be formed deeper. Therefore, the device may be robustly supported by filling the deep through-hole of the protection layer 90, which exposes the portion of the semiconductor layer for electrical connection, with the conductive material. The third electrode pad 40pd may have a thickness smaller than that of the third bump 40bp.

The third electrode pad 40pd may extend from a portion in contact with the third contact electrode 45p and disposed on the inclined surface of the protection layer 90. Further, the third electrode pad 40pd may extend from the inclined surface of the protection layer 90 to the upper surface of the protection layer 90, and may extend toward the outer side of the light emitting device 100.

A fourth bump 50bp may be disposed on an upper surface of the fourth electrode pad 50pd for electrical connection with the circuit board. The fourth electrode pad 50pd may be disposed along the fourth through-hole 50ct at a portion in contact with a fourth contact electrode 55p, and the fourth bump 50bp fills the fourth through-hole 50ct and ensures the stable electrical connection between the light emitting device 100 and the circuit board. A depth of the fourth through-hole 50ct; 50cta, 50ctb, and 50ctc filled with the fourth bump 50bp may be different from that of the third through-hole 40ct filled with the third bump 40bp, and further, may be different from that of the second through hole 20ct filled with the second bump 30bp. The fourth electrode pad 50pd may have a thickness smaller than that of the fourth bump 50bp.

The fourth through-hole 50ct filled with the fourth bump 50bp may be formed in plural, and depths of the plurality of fourth through-holes 50ct may be different from one another as indicated by arrows. The plurality of fourth through-holes 50ct; 50cta, 50ctb, and 50ctc may be deeper as they are farther from a center portion of the light emitting device.

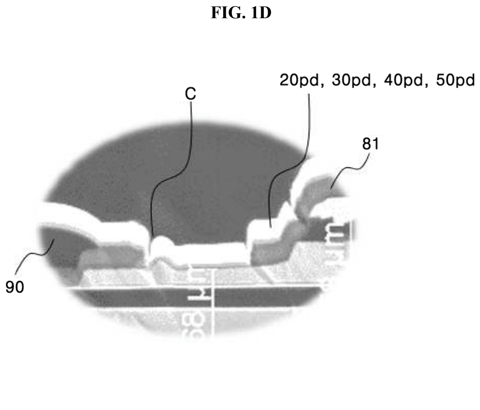

FIG. 1D is a SEM image illustrating shapes of the electrode pads 20pd, 30pd, 40pd, and 50pd formed in the contact hole of the insulation layer 81, as shown by a circular dotted line in FIG. 1C. Referring to FIG. 1D, the pad electrode 50pd formed in the contact hole 50CHb of the insulation layer 81 may include at least one depression portion C. The depression portion C may be formed to have a thickness relatively smaller than those of other regions, thereby preventing damage to the conductive material due to stress caused by the thickness. Similar to the electrode pad 50pd, the electrode pads 20pd, 30pd, and 40pd formed in the contact hole may also include at least one depression portion C, thereby preventing damage due to stress.

Hereinafter, a method of manufacturing the light emitting device 100 according to an embodiment of the present disclosure will be described. Contents described in the above-described embodiments will be briefly described or omitted.

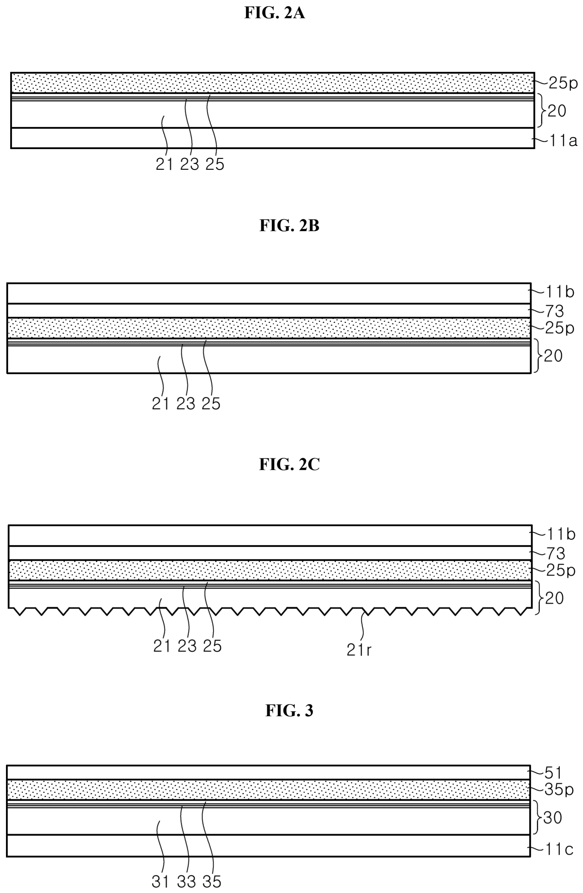

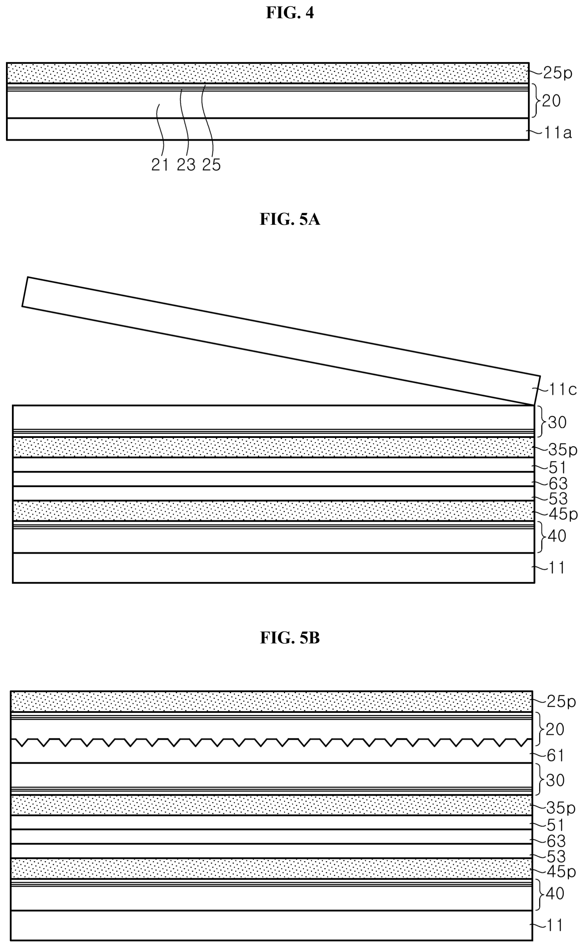

FIGs. 2A, 2B, and 2C are schematic cross-sectional views illustrating steps of providing a first LED stack according to an embodiment of the present disclosure, and FIG. 3 is a schematic cross-sectional view illustrating a step of providing a second LED stack according to an embodiment of the present disclosure, and FIG. 4 is a schematic cross-sectional view illustrating a step of providing a third LED stack according to an embodiment of the present disclosure.

First, referring to FIG. 2A, a first LED stack 20 including a first conductivity type semiconductor layer 21, an active layer 23, and a second conductivity type semiconductor layer 25 on a substrate 11a is grown. The substrate 11a may be, for example, a GaAs substrate. The first LED stack 20 may be grown by, for example, a metal organic chemical vapor deposition (MOCVD) method or a molecular beam epitaxy (MBE) method. A first upper contact electrode 25p may be formed on the second conductivity type semiconductor layer 25. The first upper contact electrode 25p may include a transparent conductive oxide (TCO) such as SnO, InO₂, ZnO, ITO, ITZO, and the like.

Referring to FIG. 2B, a carrier substrate 11b may be attached to the first upper contact electrode 25p using an adhesive 73. The carrier substrate 11b may be, for example, a sapphire substrate, without being limited thereto. After the carrier substrate 11b is attached, the substrate 11a may be removed. The substrate 11a may be removed using, for example, a wet etching technique. As the substrate 11a is removed, a lower surface of the first conductivity type semiconductor layer 21 may be exposed.

Referring to FIG. 2C, a roughened surface 21r may be formed by etching the lower surface of the first conductivity type semiconductor layer 21 using a wet or dry etching technique. As described with reference to FIG. 1B, a depth of the roughened surface 21r may in a range of about 0.1 µm to 0.9 µm. The roughened surface 21r may be a micro-optic surface. Therefore, when light generated in the first LED stack 20 is directed to a second LED stack 30, it may be focused upward by the micro-optic surface. The micro-optic surface may have an irregular shape, or may have a regular shape.

Meanwhile, referring to FIG. 3, the second LED stack 30 including a first conductivity type semiconductor layer 31, an active layer 33, and a second conductivity type semiconductor layer 35 on a substrate 11c is grown. The substrate 11c may be, for example, a sapphire substrate, without being limited thereto. The first conductivity type semiconductor layer 31, the active layer 33, and the second conductivity type semiconductor layer 35 may be sequentially grown on the substrate 11c by a metal organic chemical vapor deposition (MOCVD) method or a molecular beam epitaxy (MBE) method.

A second lower contact electrode 35p may be formed on the second conductivity type semiconductor layer 35. The second lower contact electrode 35p may be formed on the second conductivity type semiconductor layer 35 by a physical vapor deposition method or a chemical vapor deposition method. The second lower contact electrode 35p may include a transparent conductive oxide (TCO) such as SnO, InO₂, ZnO, ITO, ITZO, and the like. Furthermore, although not shown in the drawings, a first stress relief layer 51, as described with reference to FIG. 1B, may be formed on the second lower contact electrode 35p. The first stress relief layer 51 may be formed of, for example, SiO₂.

Referring to FIG. 4, a third LED stack 40 including a first conductivity type semiconductor layer 41, an active layer 43, and a second conductivity type semiconductor layer 45 may be grown on a substrate 11. The substrate 11 may be a sapphire substrate, without being limited thereto. The substrate 11 may include a roughened surface (not shown in the drawings). The first conductivity type semiconductor layer 41, the active layer 43, and the second conductivity type semiconductor layer 45 may be grown on the substrate 11 by a metal organic chemical vapor deposition (MOCVD) method or a molecular beam epitaxy (MBE) method. A third upper contact electrode 45p may be formed on the second conductivity type semiconductor layer 45. The third upper contact electrode 45p may be formed on the second conductivity type semiconductor layer 45 by a physical vapor deposition method or a chemical vapor deposition method, and may include a transparent conductive oxide (TCO) such as SnO, InO₂, ZnO, ITO, ITZO, and the like. Furthermore, although not shown in the drawings, a second stress relief layer 53 may be formed on the third upper contact electrode 45p as described with reference to FIGs. 1A, 1B, and 1C. The second stress relief layer 53 may be formed of, for example, SiO₂. According to an embodiment of the present disclosure, the third LED stack 40 may emit green light.

Referring to FIG. 5A, the second and third LED stacks 30 and 40 are coupled to each other with the second adhesive layer 63 interposed therebetween, and the substrate 11c on which the second LED stack 30 is grown may be removed by a laser lift-off process, a chemical process, a mechanical process, and the like. The stress relief layers 51 and 53 may be interposed between the second adhesive layer 63 and the second lower contact electrode 35p and the third upper contact electrode 45p, respectively. Accordingly, the second LED stack 30 and the third LED stack 40 are coupled such that second conductivity type semiconductor layer 35 of the second LED stack 30 faces the second conductivity type semiconductor layer 45 of the third LED stack 40.

Referring to FIG. 5B, the first LED stack 20 of FIG. 2C may be coupled with the second LED stack 30 with the first adhesive layer 61 interposed therebetween, and the substrate 11b to which the first LED stack 20 is attached may be removed from the first LED stack 20 together with the adhesive 73. Accordingly, the first LED stack 20 and the second LED stack 30 are coupled such that the first conductivity type semiconductor layer 21 of the first LED stack 20 faces the first conductivity type semiconductor layer 31 of the second LED stack 30.

While the LED stacks 20, 30, and 40 are bonded to one another, and the substrates 11b and 11c of the first and second LED stacks 20 and 30 are separated, warpage may occur in the substrate 11 due to a difference in thermal expansion coefficient, and as a result, cracks may occur between the LED stacks 20, 30, and 40. However, in this embodiment, by disposing the first and second stress relief layers 51 and 53 between the LED stacks 20, 30, and 40, a defect such as cracks of the LED stacks 20, 30, and 40 may be prevented from occurring.

Subsequently, the light emitting device 100 is manufactured using a coupling structure of the first LED stack 20, the second LED stack 30, and the third LED stack 40, and hereinafter, a method of manufacturing the light emitting device 100 will be described in detail.

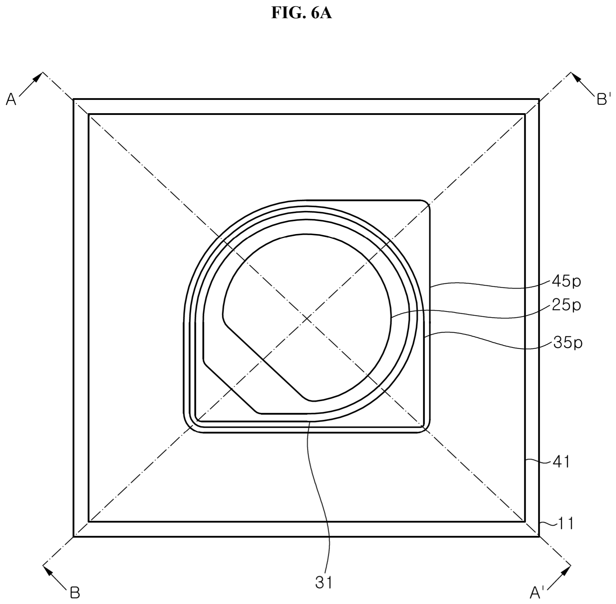

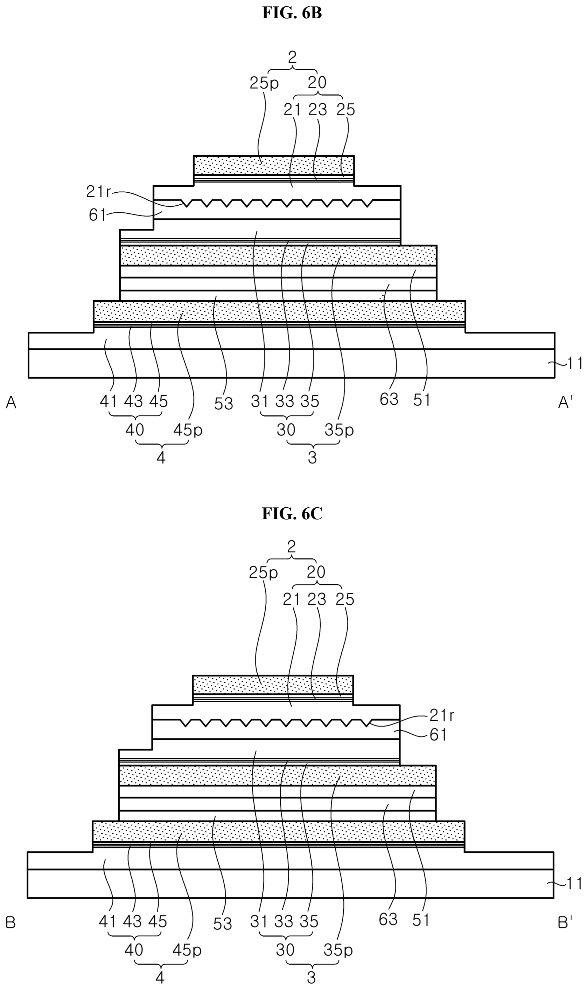

FIGs. 6A, 7A, 8A, and 9A are schematic plan views illustrating a method of manufacturing the light emitting device 100 according to an embodiment of the present disclosure. FIGs. 6B, 7B, 8B, and 9B are schematic cross-sectional views taken along line A-A' of FIGs. 6A, 7A, 8A, and 9A, and FIGs. 6C, 7C, 8C, and 9C are schematic cross-sectional views taken along line B-B' of FIGs. 6A, 7A, 8A, and 9A.

Referring to FIGs. 6A, 6B, and 6C, various portions of the first, second, and third LED stacks 20, 30, and 40, the first upper contact electrode 25p, the second lower contact electrode 35p, and the third upper contact electrode 45p may be patterned through photolithography and etching processes, and together with an upper surface of the first upper contact electrode 25p, at least a portion of each of the first conductivity type semiconductor layer 21 of the first LED stack 20, the first conductivity type semiconductor layer 31 of the second LED stack 30, the second lower contact electrode 35p, the third upper contact electrode 45p, and the first conductivity type semiconductor layer 41 of the third LED stack 40 may be exposed. The first adhesive layer 61 may be patterned together with the first conductivity type semiconductor layer 21, and the first stress relief layer 51, the second adhesive layer 63, and the second stress relief layer 53 may be patterned together with the lower contact electrode 35p. However, the inventive concepts are not limited thereto. For example, the first stress relief layer 51, the second adhesive layer 63, and the second stress relief layer 53 may be patterned through a process separate from a patterning process of the second lower contact electrode 35p.

The first LED stack 20 may have a smallest area among the LED stacks 20, 30, and 40. Meanwhile, the third LED stack 40 may have a largest area among the LED stacks 20, 30, and 40, and thus, a luminous intensity of the third LED stack 40 may be relatively increased. However, the inventive concepts are not limited thereto, and relative sizes of the LED stacks 20, 30, and 40 are not particularly limited.

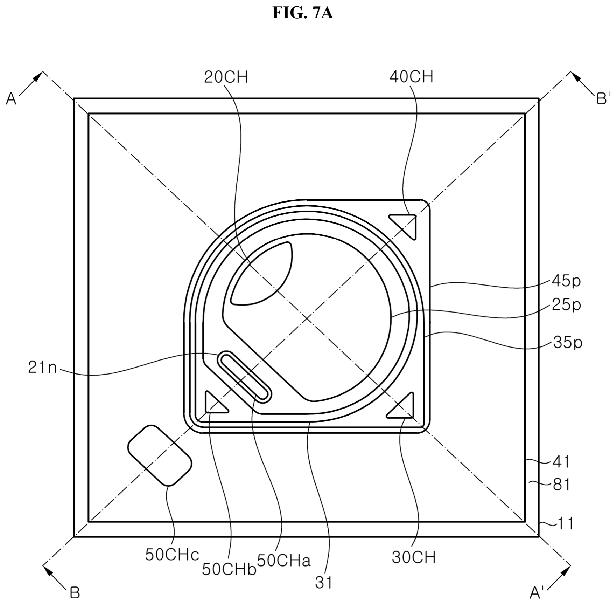

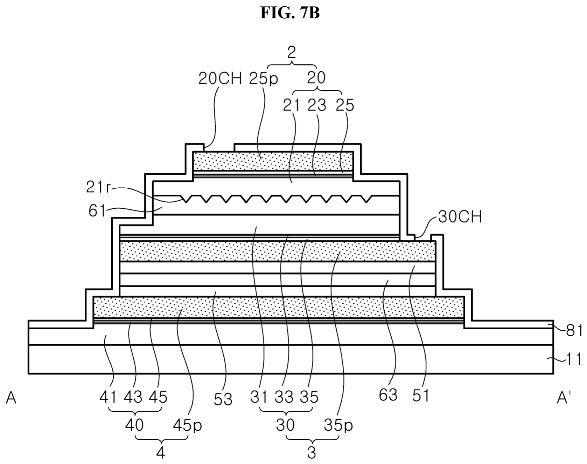

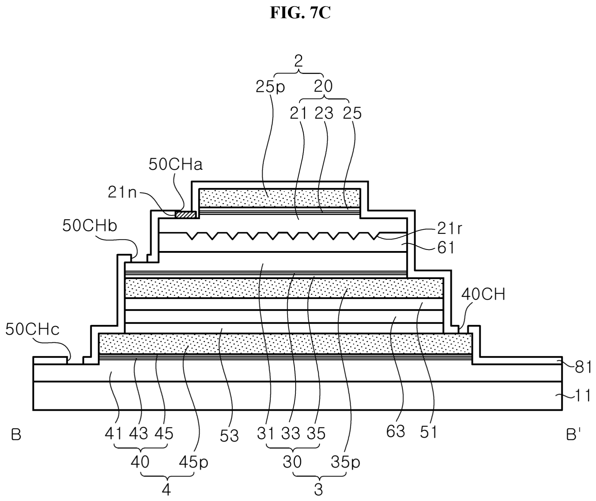

Referring to FIGs. 7A, 7B, and 7C, an ohmic contact layer 21n may be formed on the first conductivity type semiconductor layer 21 of the first LED stack 20. The ohmic contact layer 21n may be formed to have a thickness of, for example, about 100 nm in an exposed region of the first conductivity type semiconductor layer 21, thereby improving ohmic contact. The ohmic contact layer 21n may be formed of a metallic layer.

After the ohmic contact layer 21n is formed, a first insulation layer 81 may be formed. The first insulation layer 81 may be formed, for example, in a single-layer structure or a multi-layer structure. The first insulation layer 81 may include SiO₂. The first insulation layer 81 may also include a distributed Bragg reflector (DBR), and the distributed Bragg reflector, for example, may be formed by alternately stacking SiO₂ and TiO₂.

The first insulation layer 81 may be patterned to have openings to allow electrical connection to the first through third LED stacks 20, 30, and 40. For example, the first insulation layer 81 may have first, second, and third contact holes 20CH, 30CH, and 40CH exposing the first upper contact electrode 25p, the second lower contact electrode 35p, and the third upper contact electrode 45p, respectively, and first through third sub-contact holes 50CHa, 50CHb, and 50CHc exposing the ohmic contact layer 21n, the first conductivity type semiconductor layer 31, and the first conductivity type semiconductor layer 41.

The first contact hole 20CH may be defined on the first upper contact electrode 25p to expose a portion of the first upper contact electrode 25p. The second contact hole 30CH may be defined on the second lower contact electrode 35p to expose a portion of the second lower contact electrode 35p. The third contact hole 40CH may be defined on the third upper contact electrode 45p to expose a portion of the third upper contact electrode 45p. The first through third sub-contact holes 50CHa, 50CHb, and 50CHc may be formed to allow electrical connection to each of the first conductivity type semiconductor layers 21, 31, and 41 of the first, second, and third LED stacks 20, 30, and 40, and may expose the ohmic contact layer 21n, the first conductivity type semiconductor layer 31 of the second LED stack 30, and the first conductivity type semiconductor layer 41 of the third LED stack 40, respectively.

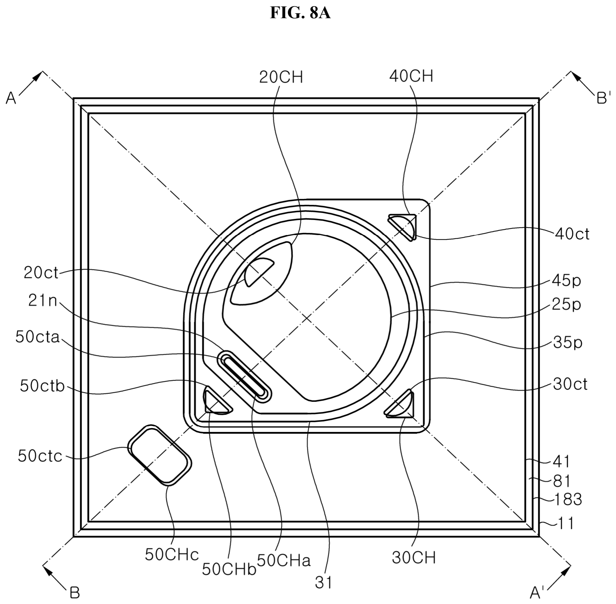

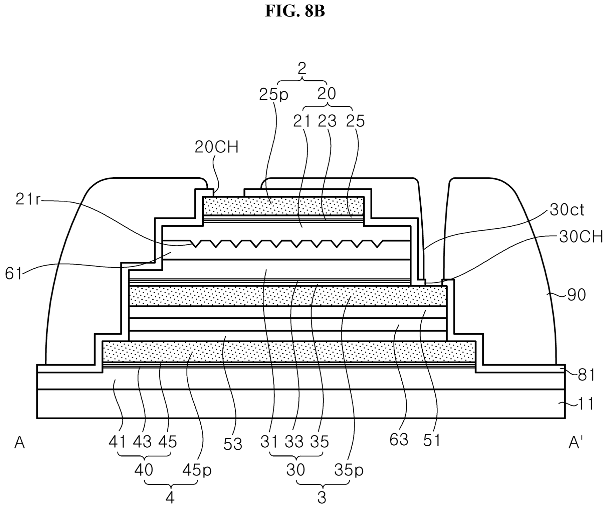

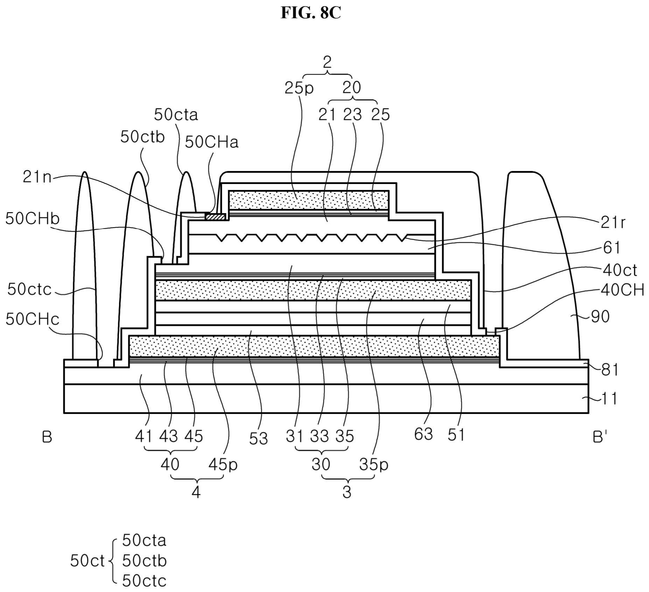

Referring to FIGs. 8A, 8B, and 8C, a protection layer 90 may be formed on the first insulation layer 81. The protection layer 90 may include epoxy molding compound (EMC), without being limited to. For example, the protection layer 90 may be formed of a photosensitive polyimide dry film (PID). The protection layer 90 may be transparent or have various colors such as black, white, or others, and may prevent light from leaking to a side surface of the light emitting device 100 to prevent or suppress interference of light emitted from an adjacent light emitting device 100.

The protection layer 90 may be formed directly on the first insulation layer 81, and thus, no other layers, such as a conductive layer, are interposed between the first insulation layer 81 and the protection layer 90. The first insulation layer 81 is affected by a surface on which it is formed, and accordingly, cracks may be formed in the first insulation layer 81. The protection layer 90 may fill the cracks in the first insulation layer 81 to form a smooth surface, thereby improving a reliability of electrode pads 20pd, 30pd, 40pd, and 50pd, which will be described later. Although the protection layer 90 is described as being formed directly on the first insulation layer 81, the inventive concepts are not necessarily limited thereto, and an additional layer may be formed on the first insulation layer 81 before the protection layer 90 is formed.

The protection layer 90 may be patterned to allow electrical connection to the first through third LED stacks 20, 30, and 40. The protection layer 90 may be patterned using photolithography and development processes. For example, the protection layer 90 may be patterned to have through-holes 20ct, 30ct, 40ct, 50cta, 50ctb, and 50ctc corresponding to the first through third contact holes 20CH, 30CH, and 40CH and the first through third sub-contact holes 50CHa, 50CHb, and 50CHc of the first insulation layer 81. A first through-hole 20ct may at least partially overlap with the first contact hole 20CH, a second through-hole 30ct may at least partially overlap with the second contact hole 30CH, and a third through-hole 40ct may at least partially overlap with the third contact hole 40CH. In addition, first through third sub through-holes 50cta, 50ctb, and 50ctc may at least partially overlap with the first through third sub-contact holes 50CHa, 50CHb, and 50CHc, respectively.

In this embodiment, it is described that the first through third sub through-holes 50cta, 50ctb, and 50ctc are formed, but one opening exposing the first through third contact holes 50CHa, 50CHb, and 50Chc may be formed.

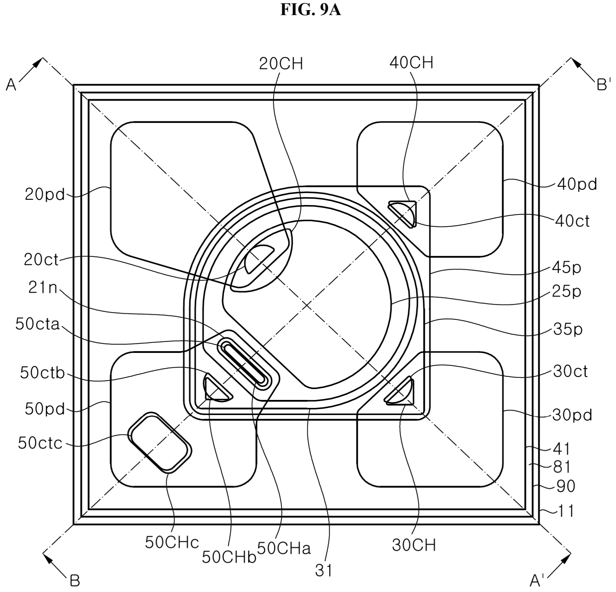

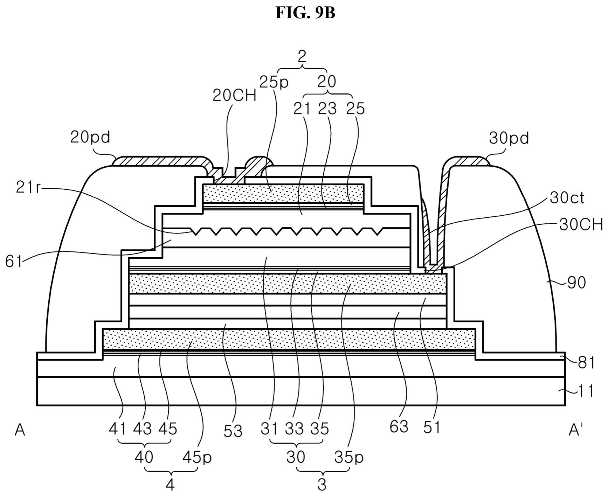

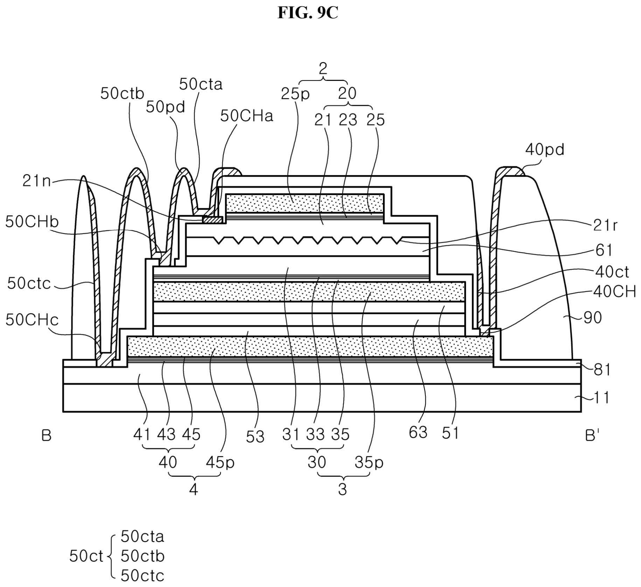

Referring to FIGs. 9A, 9B, and 9C, the first, second, third, and fourth electrode pad layers 20pd, 30pd, 40pd, and 50pd are formed on the protection layer 90. The first through fourth electrode pads 20pd, 30pd, 40pd, and 50pd may be arranged in a diagonal direction of a substrate 11, as shown in FIG. 9A. The first, second, third, and fourth electrode pad layers 20pd, 30pd, 40pd, and 50pd may be formed by forming conductive layers on an entire surface of the substrate 11 and patterning them using photolithography and etching processes, or may be formed using a lift-off process.

The first electrode pad **layer** 20pd may be electrically connected to the first contact electrode 25p through the first through-hole 20ct and the first contact hole 20CH, and may be electrically connected to the second conductivity type semiconductor layer 25 through the first contact electrode 25p. The second electrode pad **layer** 30pd may be electrically connected to the second contact electrode 35p through the second through-hole 30ct and the second contact hole 30CH, and may be electrically connected to the second conductivity type semiconductor layer 35 through the second contact electrode 35p. The third electrode pad **layer** 40pd may be connected to the third contact electrode 45p through the third through-hole 40ct and the third contact hole 40CH, and may be electrically connected to the second conductivity type semiconductor layer 45 through the third contact electrode 45p. The fourth electrode pad **layer** 50pd may be connected to the ohmic contact layer 21n, the first conductivity type semiconductor layer 31, and the first conductivity type semiconductor layer 41 through the first through third sub through-holes 50cta, 50ctb, and 50ctc and the first through third sub-contact holes 50CHa, 50CHb, and 50Chc. The fourth electrode pad **layer** 50pd may be commonly electrically connected to the first conductivity type semiconductors 21, 31, and 41 of the first, second, and third LED stacks 20, 30, and 40.

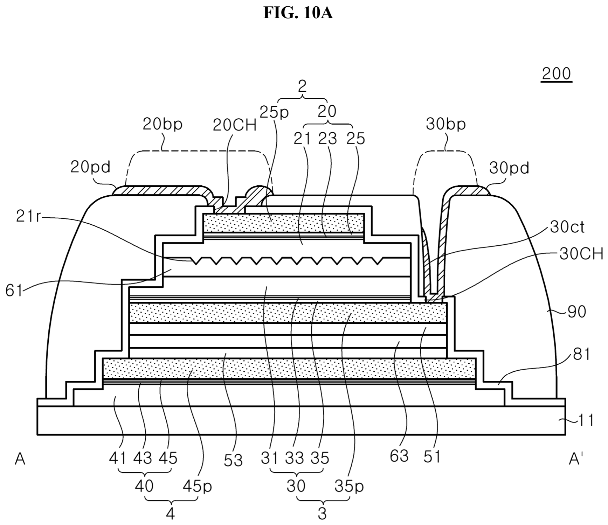

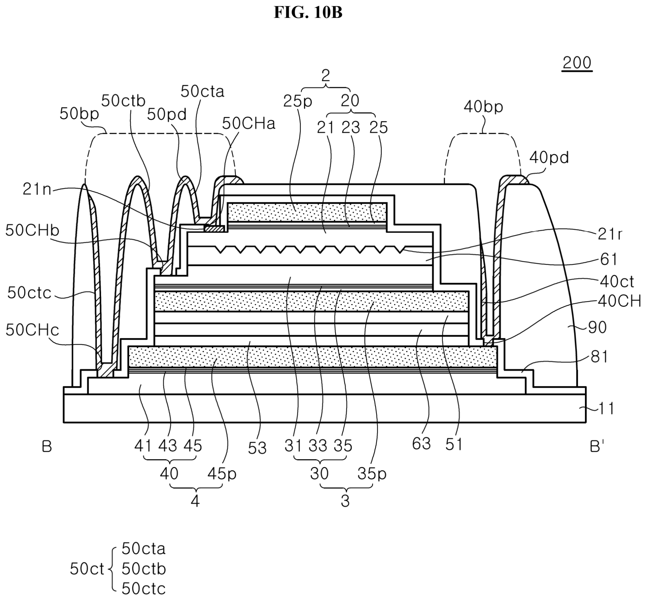

FIGs. 10A and 10B are schematic cross-sectional views illustrating a light emitting device according to another embodiment of the present disclosure.

Referring to FIGs.10A and 10B, a light emitting device 200 according to this embodiment is generally similar to the light emitting device 100 described with reference to FIGs. 1A, 1B, and 1C, except that an outer edge of a first conductivity type semiconductor layer 41 is disposed inside a region surrounded by an edge of a substrate 11. Accordingly, a portion of an upper surface of the substrate 11 may be exposed outside of the first conductivity type semiconductor layer 41. A first insulation layer 81 covers a semiconductor layer, and may extend outward to cover an exposed region of the substrate 11. Furthermore, a protection layer 90 may cover at least a portion of an upper surface of the first insulation layer 81 covering the substrate 11. An edge of the first insulation layer 81 may be exposed to the outside of the protection layer 90, but the inventive concepts are not limited thereto, and the protection layer 90 may cover the edge of the first insulation layer 81. Since the outer edge of the first conductivity type semiconductor layer 41 is disposed inward from the edge of the substrate 11 and a region near an outer edge of the substrate 11 is covered with a plurality of insulating materials, it is possible to prevent moisture from infiltrating into the semiconductor layer of the light emitting device.

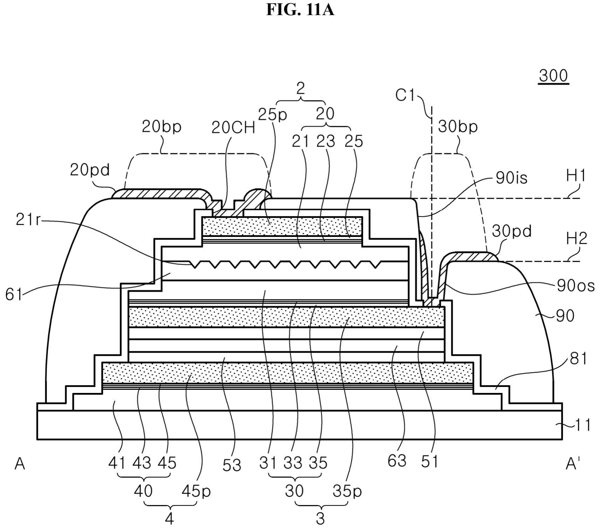

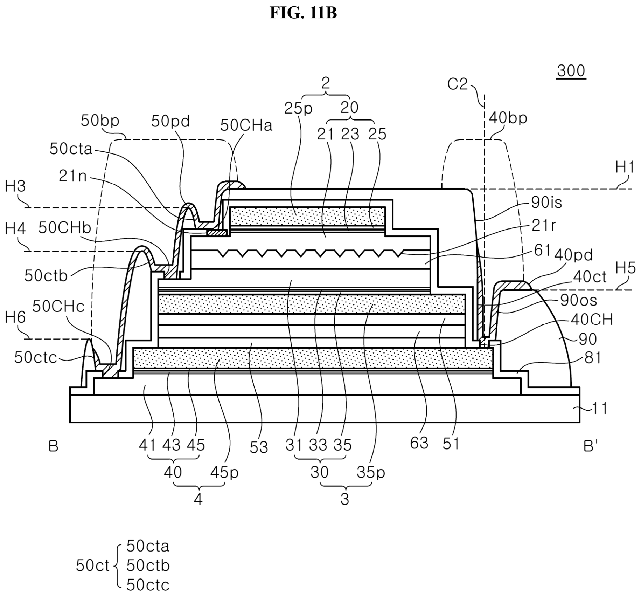

FIGs. 11A and 11B are schematic cross-sectional views illustrating a light emitting device 300 according to another embodiment of the present disclosure.

Referring to FIGs. 11A and 11B, the light emitting device 300 according to this embodiment is generally similar to the light emitting device 100 described with reference to FIGs. 1A, 1B, and 1C or the light emitting device 200 described with reference to FIGs. 10A and 10B, except a shape of a protection layer 90. That is, in the cross-sectional views of the light emitting device 300, an inner surface 90is and an outer surface 90os of each of through-holes 30ct, 40ct, 50cta, 50ctb, and 50ctc may be asymmetric with respect to center lines of the through-holes.

First, referring to FIG. 11A, a cross-sectional shape of a second through-hole 30ct of the protection layer 90 may include the inner surface 90is close to a center of the light emitting device and the outer surface 90os close to an edge of a substrate, and the inner surface 90is and the outer surface 90os may be asymmetric with respect to a center line C1 of the second through-hole 30ct. For example, a slope of the inner surface 90is and a slope of the outer surface 90os of the second through-hole 30ct may be different from each other. In addition, a height H1 of a highest point of the inner surface 90is may be different from a height H2 of a highest point of the outer surface 90os, and the highest point of the outer surface 90os may be disposed lower than the highest point of the inner surface 90is. In addition, a curvature of the inner surface 90is and a curvature of the outer surface 90os may be different from each other.

Referring to FIG. 11B, a cross-sectional shape of a third through-hole 40ct of the protection layer 90 may include an inner surface 90is close to the center of the light emitting device 300 and an outer surface 90os close to the edge of the substrate 11, and the inner surface and the outer surface may be asymmetric with respect to a center line C2 of the third through-hole 40ct. For example, a slope of the inner surface 90is and a slope of the outer surface 90os of the third through-hole 40ct may be different. In addition, a height H1 of a highest point of the inner surface 90is may be different from a height H5 of a highest point of the outer surface 90os, and the highest point of the outer surface 90os may be disposed lower than the highest point of the inner surface 90is. In addition, curvatures of the inner surface 90is and the outer surface 90os of the third through-hole 40ct may be different from each other. The height H5 of the highest point of the outer surface 90os of the third through-hole 40ct may be different from the height H2 of the highest point of the outer surface 90os of the second through-hole 30ct, and the highest point of the outer surface 90os of the third through-hole 40ct may be lower than the highest point of the outer surface 90os of the second through-hole 30ct.

A fourth through-hole 50ct of the protection layer 90 may be formed of a plurality of sub through-holes 50cta, 50ctb, and 50ctc, and each side surface of the plurality of sub through-holes 50cta, 50ctb, and 50ctc may include an inner surface 90is relatively closer to the center of the light emitting device 300 and an outer surface 90os relatively closer to the edge of the substrate 11. A length of each side surface may be different from one another, or a slope of each side surface may be different from one another. Alternatively, a curvature of each side surface may be different from one another. The protection layer 90 forming the fourth through-hole 50ct includes an inner surface 90is and an outer surface 90os centered on each of the plurality of sub through-holes 50cta, 50ctb, and 50cta. The protection layer 90 may include points having different heights H3 and H4 between the sub through-holes 50ct, 50ctb, and 50ctc. These heights H3 and H4 may be disposed lower than a height of an inner surface of a first sub through-hole 50cta. As a distance from the center of the light emitting device 300 increases, a height point of the outer surfaces 90os of the protection layer 90 may become lower. A height H6 of a highest point on an outer surface of a third sub through-hole 50ctc may be disposed lower than the heights H3 and H4, and the height H4 may be disposed lower than the height H3. Each point of the heights H3, H4, and H6 may become lower or may become closer to an upper surface of the substrate 11 as the distance from the center of the light emitting device 300 increases. Therefore, even when the fourth electrode pad 50pd passes through a plurality of height points of the protection layer 90 to connect the plurality of sub through-holes 50cta, 50ctb, and 50ctc, it is possible to prevent disconnection in the fourth electrode pad 50pd due to a height difference.

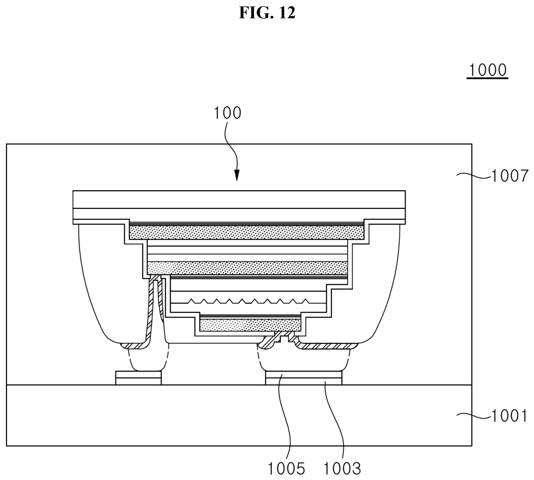

FIG. 12 is a schematic cross-sectional view illustrating a pixel module 1000 including a light emitting device 100 according to an embodiment. Herein, the light emitting device 100 is exemplarily described, but a light emitting device 200 or 300 may be included instead of the light emitting device 100, and the light emitting device 200 or 300 may be included together with the light emitting device 100. In addition, the pixel module 1000 here is a display module used in a display apparatus as a light emitting module including a single pixel or a plurality of pixels.

Referring to FIG. 12, the light emitting device 100 may be bonded to a circuit board 1001 to be electrically connected to the circuit board 1001. The light emitting device 100 may be bonded to pads 1003 on the circuit board 1001 using the first through fourth bumps 20bp, 30bp, 40bp, and 50bp described with reference to FIGs. 1B and 1C. A bonding material 1005 may be further formed on the pads 1003. The first through fourth bumps 20bp, 30bp, 40bp, and 50bp may be applied first to the pads 1003, or may be applied on electrode pads 20pd, 30pd, 40pd, and 50pd of the light emitting device 100. An interval between the pads 1003 on the circuit board 1001 may be larger than an interval between pixel device pads. Meanwhile, an interval between lower surfaces of the bonding materials 1005 may be larger than an interval between upper surfaces thereof.

A plurality of light emitting devices 100 may be arrayed on the circuit board 1001, and a molding layer 1007 may cover the plurality of light emitting devices 100. The molding layer 1007 is not particularly limited as long as it is a light-transmitting material. A thickness of the light emitting device 100 may be smaller than a distance from an upper surface of the molding layer 1007 from which light is emitted to an upper surface of the light emitting device 100 in contact with the molding layer 1007. Therefore, it is possible to reduce thicknesses of the pixel module and the display apparatus, and thus, a distance between a user's eyes and the light emitting devices 100, 200, and 300 may be reduced when viewed from the outside, thereby further improving visibility.

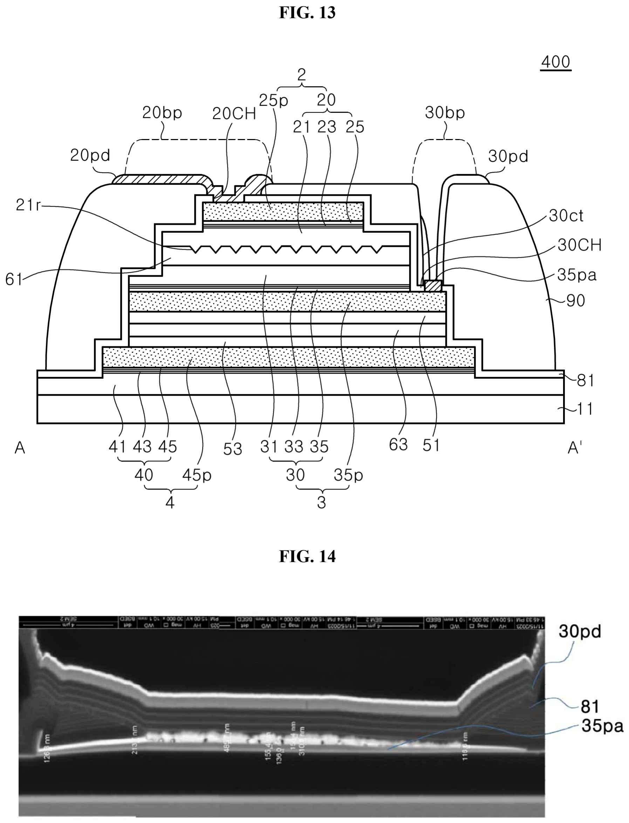

FIG. 13 is a schematic cross-sectional view illustrating a light emitting device 400 according to another embodiment of the present disclosure.

Referring to FIG. 13, the light emitting device 400 according to this embodiment is generally similar to the light emitting device 100 described with reference to FIGs. 1A, 1B, and 1C, except that a bridge electrode 35pa is further included.

Like the light emitting devices 100, 200, and 300 of the previous embodiments, in the light emitting device 400, a first conductivity type semiconductor layer 31 of a second LED stack 30 may be disposed between a first conductivity type semiconductor layer 21 of a first LED stack 20 and a second conductivity type semiconductor layer 35 of the second LED stack 30. In addition, the second conductivity type semiconductor layer 35 of the second LED stack 30 may be disposed between the first conductivity type semiconductor layer 31 of the second LED stack 30 and a second conductivity type semiconductor layer 45 of a third LED stack 40.

According to an embodiment, a second contact electrode 35p electrically connected to the second conductivity type semiconductor layer 35 of the second LED stack 30 may extend outward from an outer surface of the second LED stack 30 and may be exposed to an outer side of the second LED stack 30. An externally supplied electrical signal may be supplied to the second LED stack 30 through an exposed region of the second contact electrode 35p.

The second contact electrode 35p is electrically connected to the second LED stack 30. The second contact electrode 35p may be electrically connected to the second conductivity type semiconductor layer 35 of the second LED stack 30. Meanwhile, the bridge electrode 35pa is disposed on the second contact electrode 35p. The bridge electrode 35pa may be disposed on the second contact electrode 35p exposed to the outside of the second LED stack 30, and may be electrically connected to the second conductivity type semiconductor layer 35 of the second LED stack 30 through the second contact electrode 35p. The bridge electrode 35pa connects the second electrode pad 30pd to the second contact electrode 35p. That is, the second electrode pad 30pd may be electrically connected to the bridge electrode 35pa. The bridge electrode 35pa may include at least one same material as that of a first ohmic electrode 21n, or may include at least one different material from that of the first ohmic electrode 21n.

The bridge electrode 35pa may have a thermal expansion coefficient different from that of the first ohmic electrode 21n. Since different electrodes are disposed at different distances from a circuit board, a degree to which they are affected by heat may be different. Therefore, electrode peeling occurrence due to thermal expansion may be prevented by arranging electrodes having different thermal expansion coefficients.

The bridge electrode 35pa may have a thermal conductivity different from that of the first ohmic electrode 21n. Since an amount of heat transferred may vary depending on where each of the electrodes is disposed, heat may be transferred effectively by disposing electrodes with different thermal conductivities.

The bridge electrode 35pa may have a thickness different from that of the second contact electrode 35p. The bridge electrode 35pa may be thicker than the second contact electrode 35p.

A first insulation layer 81 may cover the bridge electrode 35pa. A second contact hole 30CH of the first insulation layer 81 may expose one surface of the bridge electrode 35pa. A height of a bottom surface of the second contact hole 30CH may be same as a height of an upper surface of the bridge electrode 35pa. For example, after the bridge electrode 35pa is formed on the second contact electrode 35p, the first insulation layer 81 may be deposited, and the second contact hole 30CH may be formed by performing photolithography and etching processes on the first insulation layer 81. In this case, the second contact hole 30CH may be formed such that the bottom surface of the second contact hole 30CH of the first insulation layer 81 is disposed on the bridge electrode 35pa. In another embodiment, a height of the second contact hole 30CH of the first insulation layer 81 may be disposed lower than that of the upper surface of the bridge electrode 35pa. In addition, as shown in the drawings, the height of the bottom surface of the second contact hole 30CH may be same as that of the upper surface of the second contact electrode 35p.

In an embodiment, a side surface of the second LED stack 30 facing a side surface of the bridge electrode 35pa may be inclined. An inclination of the side surface of the bridge electrode 35pa may be in an opposite direction to an inclination of the side surface of the second LED stack 30 facing it. In cross-section view, a horizontal distance from the side surface of the bridge electrode 35pa to the side surface of the second LED stack 30 may increase or decrease as height changes.

The bridge electrode 35pa may include a plurality of metallic layers. Portions of the plurality of metallic layers may have a structure in which metallic layers having different conductivities or different reflectances are alternately stacked.

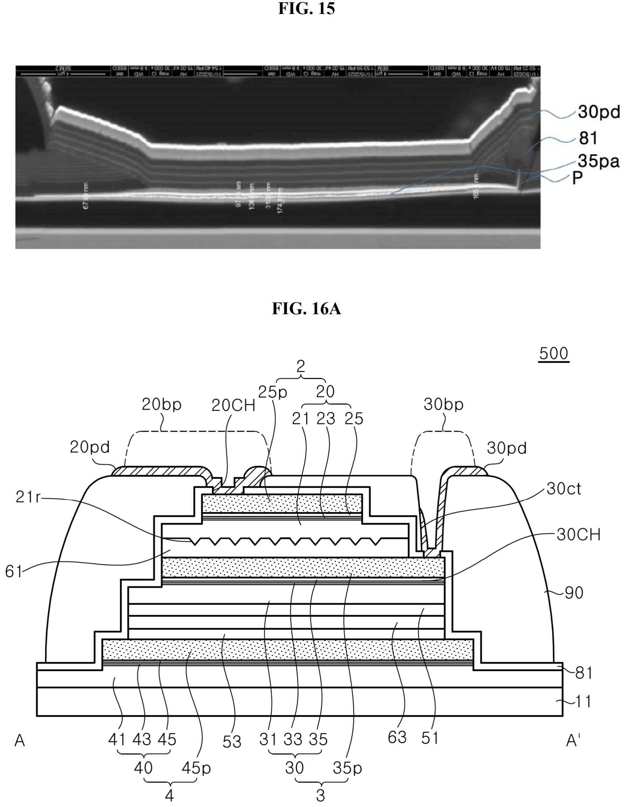

FIG. 14 is a SEM image illustrating a bridge electrode formed on a second contact electrode, and FIG. 15 is a SEM image illustrating a bridge electrode of another embodiment. FIGs. 14 and 15 are examples of bridge electrodes 35pa having different metal layer structures.

First, referring to FIG. 14, an upper surface of the bridge electrode 35pa may include regions with different morphologies. As shown in FIG. 14, a central region of the upper surface of the bridge electrode 35pa may have a morphology different from that of a region around thereof. A morphology of an interface (first region) of the bridge electrode 35pa in contact with a second electrode pad 30pd may be different from that of the upper surface (second region) of the bridge electrode 35pa covered with a first insulation layer 81. The interface of the bridge electrode 35pa in contact with the second electrode pad 30pd may be relatively non-uniform than the region around the upper surface of the bridge electrode 35pa. In addition, a thickness of the first region may be larger than that of the second region. Due to the non-uniform morphology, an area of the interface in contact with the second electrode pad 30pd increases, and thus, a stability of an electrical connection between the second electrode pad 30pd and the bridge electrode 35pa may be improved.

Referring to FIG. 15, an upper surface morphology of the bridge electrode 35pa according to this embodiment may have a substantially smooth surface. The bridge electrode 35pa may be formed of a plurality of layers, and may be formed by stacking two or more pairs of materials with different thermal expansion coefficients or thermal conductivities. Therefore, even when heat is generated, the smooth surface may be maintained. The bridge electrode 35pa may include at least one material having a thermal conductivity of 50W/(m·k) or more. Alternatively, the bridge electrode 35pa may include at least one material having a thermal expansion coefficient of 10 µm/(m·K). A thickness of the bridge electrode 35pa in the region in contact with the second electrode pad 30pd may be larger than that of the bridge electrode 35pd in a region in contact with the first insulation layer 81. The bridge electrode 35pd may include at least one material selected from Ti, Ni, Au, or Al. Meanwhile, as shown in FIG. 15, one end of the bridge electrode 35pa may include a bent portion P that is bent. The bent portion P may be disposed outside the interface where the bridge electrode 35pa is in contact with the second electrode pad 30pd. The bent portion P may extend toward the first insulation layer 81, and may be buried by the first insulation layer 81. A bonding force between the bridge electrode 35pa and the first insulation layer 81 may be increased by the bent portion P.

In this embodiment, the bridge electrode 35pa is described as being formed on the second contact electrode 35p, but the bridge electrode may also be formed on a first contact electrode 25p and/or a third contact electrode 45p.

The light emitting device 400 according to this embodiment may be modularized into the pixel module 1000 as described with reference to FIG. 12, and may be used in a display apparatus. A detailed description of the pixel module 1000 will be omitted to avoid redundancy.

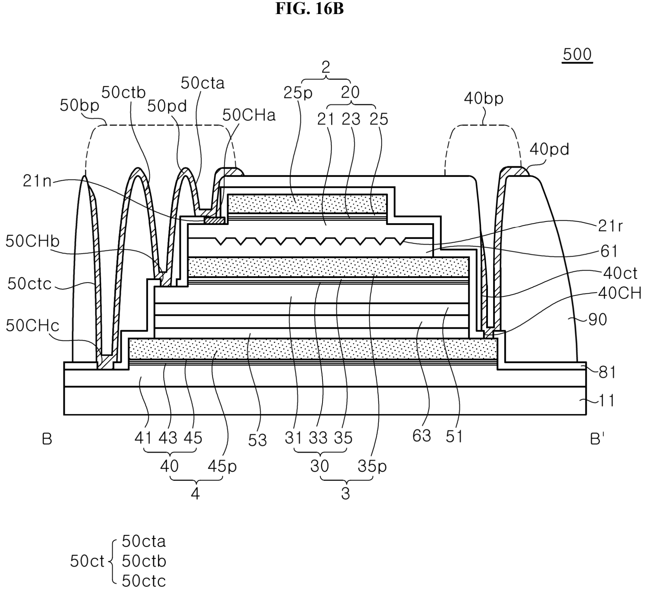

FIGs. 16A and 16B are schematic cross-sectional views illustrating a light emitting device 500 according to another embodiment of the present disclosure.

Referring to FIGs. 16A and 16B, the light emitting device 500 according to this embodiment is generally similar to the light emitting device 100 described with reference to FIGs. 1A, 1B, and 1C, except that a stacking order of a second subunit 3 is different. That is, in this embodiment, a second contact electrode 35p is disposed between a second LED stack 30 and a first LED stack 20. In addition, a first conductivity type semiconductor layer 31 of the second LED stack 30 is disposed between a second conductivity type semiconductor layer 45 of a third LED stack 40 and a second conductivity type semiconductor layer 35 of the second LED stack 30.

Arrangement orders of first conductivity type semiconductor layers 21, 31, and 41 and second conductivity type semiconductor layers 25, 35, and 45 of the first LED stack 20, the second LED stack 30, and the third LED stack 40 may be same. Therefore, when viewed based on the semiconductor layers, the first conductivity type semiconductor layers 21, 31, and 41 and the second conductivity type semiconductor layers 25, 35, and 45 may be arranged regularly.

According to an embodiment of the invention, polarities of the semiconductor layers of the LED stacks 20 and 40 disposed over and under the second LED stack 30 may be asymmetric. For example, the first conductivity type semiconductor layer 21 of the first LED stack 20 may be disposed farther than the second conductivity type semiconductor layer 25 from the second LED stack 30, and the first conductivity type semiconductor layer 41 of the third LED stack 40 may be disposed closer than the second conductivity type semiconductor layer 45 to the second LED stack 30.

Furthermore, the polarities of the semiconductor layers of the first, second, and third LED stacks 20, 30, and 40 may be arranged in a same direction. For example, p-type semiconductor layers of each of the first, second, and third LED stacks 20, 30, and 40 may be disposed farther than n-type semiconductor layers from a substrate 11, and may be disposed closer to a circuit board in a module. A dopant of the p-type semiconductor layer may provide a carrier with a mobility relatively lower than that of a dopant of the n-type semiconductor layer, and by disposing the p-type semiconductor layer closer to the circuit board on which an electrode with relatively high thermal conductivity is disposed, luminous efficiency may be improved by increasing the mobility of the carrier in the p-type semiconductor layer through heat transferred from the circuit board or electrode.

The first, second, and third LED stacks 20, 30, and 40 may have the first conductivity type semiconductor layer 21, 31, and 41 and the second conductivity type semiconductor layers 25, 35, and 45, respectively, and among the first conductivity type semiconductor layers 21, 31, and 41 and the second conductivity type semiconductor layers 25, 35, and 45, a thickness of a semiconductor layer disposed closer to the circuit board, that is, a thickness of a semiconductor layer disposed farther from the substrate 11 may be smaller. Therefore, by disposing the thicker semiconductor layer in a light exiting direction, a sufficient mixing region may be secured such that light emitted from each of the first, second, and third LED stacks 20, 30, and 40 is sufficiently mixed.

The semiconductor layers of the first, second, and third LED stacks 20, 30, and 40 may include different types of first and second impurities, and among the first and second impurities, a layer including impurities providing slow mobility carriers may be disposed farther from the substrate 11, or disposed closer to the circuit board. The first impurity may be silicon (Si), and the second impurity may be magnesium (Mg). The second impurity may provide a carrier with a mobility relatively lower than that of the first impurity, and by disposing a semiconductor layer including the second impurity closer to the circuit board on which the electrode with relatively high thermal conductivity is disposed, the mobility of the carrier provided by the second impurity is increased through heat transferred from the circuit board or electrode, thereby improving luminous efficiency.

The semiconductor layers of the first, second, and third LED stacks 20, 30, and 40 include the first conductivity type semiconductor layers 21, 31, and 41, and contact layers of each of the first conductivity type semiconductor layer 21, 31, and 41 that the electrode pad 50pd contacts may have different doping concentrations from one another.

The semiconductor layers of the first, second, and third LED stacks 20, 30, and 40 include the first conductivity type semiconductor layers 21, 31, 41 and the second conductivity type semiconductor layers 25, 35, and 45, and a semiconductor layer including a first layer with a highest band gap energy among the first conductivity type semiconductor layers and the second conductivity type semiconductor layers may be disposed closer to the circuit board. Since the semiconductor layer including the first layer is disposed closer to the circuit board, the band gap energy of the semiconductor layer including the first layer may relatively lowered by heat generated from the circuit board, allowing carriers to be smoothly injected into an active layer.

The semiconductor layers of the first, second, and third LEDs 20, 30, and 40 include the first conductivity type semiconductor layers 21, 31, and 41, the second conductivity type semiconductor layers 25, 35, and 45, and active layers 23, 33, and 43 disposed between the first conductivity type semiconductor layers 21, 31, and 41 and the second conductivity type semiconductor layers 25, 35, and 45, and the active layer in each LED stack may be disposed closer to the circuit board from a center of the corresponding LED stack. The heat generated from the circuit board may lower band gap energies of barrier layers in the active layers 23, 33, and 43, allowing the carrier provided by the second impurity in the second conductivity type semiconductor layer to be smoothly injected into well layers in the active layers.

Distances from lower surfaces of each of the first, second, and third LED stacks 20, 30, and 40 to each active layer of the corresponding LED stack may be different from one another.

Distances from upper surfaces of each of the first, second, and third LED stacks 20, 30, and 40 to each active layer of the corresponding LED stack may be different from one another.

The semiconductor layers of the first, second, and third LED stacks 20, 30, and 40 may include the first conductivity type semiconductor layers 21, 31, 41 and the second conductivity type semiconductor layers 25, 35, and 45, and, in the module, each first conductivity type semiconductor layer may be disposed closer to the outside than the second conductivity type semiconductor layer in a same LED stack. Therefore, since the first conductivity type semiconductor layer is further cooled by external air, a temperature of the first conductivity type semiconductor layer may be made relatively lower than that of the second conductivity type semiconductor layer, and thus, the mobility of the carrier in the first conductivity type semiconductor layer may be made small, thereby reducing a difference with the mobility of the carrier in the second conductivity type semiconductor layer.

A first adhesive layer 61 may be disposed between the first LED stack 20 and the second LED stack 30, and the first LED stack 20 and the second LED stack 30 face each other with respect to the first adhesive layer 61 may have different polarities from each other.

A second adhesive layer 63 may be disposed between the second LED stack 30 and the third LED stack 40, and the second LED stack 30 and the third LED stack face each other with respect to the second adhesive layer 63 may have different polarities from each other.

The semiconductor layers of the first, second, and third LED stacks 20, 30, and 40 include the first conductivity type semiconductor layers 21, 31, and 41, the second conductivity type semiconductor layers 25, 35, and 45, and the active layers 23, 33, and 43 disposed between the first conductivity type semiconductor layers and the second conductivity type semiconductor layers. In this case, a vertical light path for light generated in the active layer 23 of the first LED stack 20 to escape the first LED stack 20 may be longer at an upper portion than at a lower portion.

The semiconductor layers of the first, second, and third LED stacks 20, 30, and 40 include the first conductivity type semiconductor layers 21, 31, and 41, the second conductivity type semiconductor layers 25, 35, and 45, and the active layers 23, 33, and 43 disposed between the first conductivity type semiconductor layers and the second conductivity type semiconductor layers. In this case, a vertical light path for light generated in the active layer of the second LED 30 to escape the second LED stack 30 may be longer at an upper portion than at a lower portion.

The semiconductor layers of the first, second, and third LED stacks 20, 30, and 40 include the first conductivity type semiconductor layers 21, 31, and 41, the second conductivity type semiconductor layers 25, 35, and 45, and the active layers 23, 33, and 43 disposed between the first conductivity type semiconductor layers and the second conductivity type semiconductor layers. In this case, a vertical light path for light generated in the active layer of the third LED stack 40 to escape the third LED stack 40 may be longer at an upper portion than at a lower portion.

According to this embodiment, the second contact electrode 35p is disposed on the second LED stack 30. Therefore, there is no need for the second contact electrode 35p to protrude to the outside of the second LED stack 30 for electrical connection. A second contact hole 30CH of a first insulation layer 81, which exposes the second contact electrode 35p, may be disposed over the second LED stack 30. Therefore, since the second contact electrode 35p may be supported by the second LED stack 30, a structural stability of the second contact electrode 35p may be improved.

In an embodiment, the second subunit 3 formed on a growth substrate may first be attached on a temporary substrate, thereafter, the growth substrate is removed, and then, the second subunit 3 may be bonded to a third subunit 4 and the temporary substrate may be removed. In another embodiment, the second subunit 3 formed on the growth substrate may first be bonded to a first subunit 2, and then, the growth substrate may be removed. Subsequently, the first subunit 2 and the second subunit 3 may be bonded together to the third subunit 4. Through this manufacturing process, the light emitting device 500 having a sequence shown in FIGs. 16A and 16B may be manufactured.

In this embodiment, a bridge electrode 35pa as described with reference to FIG. 13 may be further disposed on the second contact electrode 35p, and the bridge electrode 35pa may have a same shape as described with reference to FIGs. 14 and 15. The bridge electrode 35pa may also be formed on a first contact electrode 25p and/or a third contact electrode 45p.

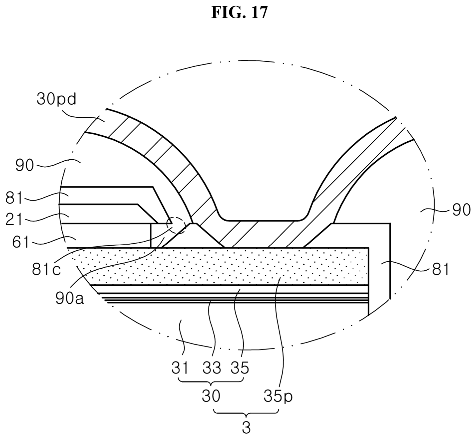

FIG. 17 is a schematic cross-sectional view enlarging a circular dotted line portion of FIG. 16A.

Referring to FIG. 17, the first insulation layer 81 covers the second contact electrode 35p together with the first conductivity type semiconductor layer 21 of the first LED stack 20, and has the second contact hole 30CH exposing the second contact electrode 35p. A crack 81c may be formed in the first insulation layer 81 due to a step formed by heights of the first conductivity type semiconductor layer 21 and the first adhesive layer 61. In particular, the first adhesive layer 61 may be recessed inward from an outer end of the first conductivity type semiconductor layer 21. A protection layer 90 may fill concave portions formed by the cracks in the first insulation layer 81. Various steps may be formed on a surface where the first insulation layer 81 is formed, and accordingly, cracks may be formed in various positions of the first insulation layer 81. The protection layer 90 may fill the cracks formed in the various positions of the first insulation layer 81 to provide a smooth surface.

Since the protection layer 90 fills the cracks formed in the first insulation layer 81, an electrode pad 30pd formed on the protection layer 90 may be formed on the smooth surface, and accordingly, an electrical and structural stability of the electrode pad 30pd may be improved. Electrode pads 20pd, 40pd, and 50pd may also be formed on the smooth surface by the protection layer 90, and thus, their electrical and structural stability may be improved.

In this embodiment, it is described that the light emitting device 500 is generally similar to the light emitting device 100 described with reference to FIGs. 1A, 1B, and 1C, but a configuration applied to the light emitting devices 200, 300, and 400 may be applied to the light emitting device 500.

The light emitting device 500 according to this embodiment may be modularized into the pixel module 1000 as described with reference to FIG. 12, and may be used in a display apparatus. The pixel module 1000 may include a plurality of light emitting devices 500 mounted on a circuit board 1001. A detailed description of the pixel module 1000 will be omitted to avoid redundancy. However, a molding layer 1007 may be disposed to cover the first, second, and third LED stacks 20, 30, and 40 and the circuit board 1001. In addition, the molding layer 1007 may fill regions between the plurality of light emitting devices 500. The molding layer 1007 may be light transmissive. The molding layer 1007 may include particles. The particles may be light-reflecting or light-absorbing materials. The particles may be changed by changing a light path, or decreasing or increasing an amount of light emitted to the outside.

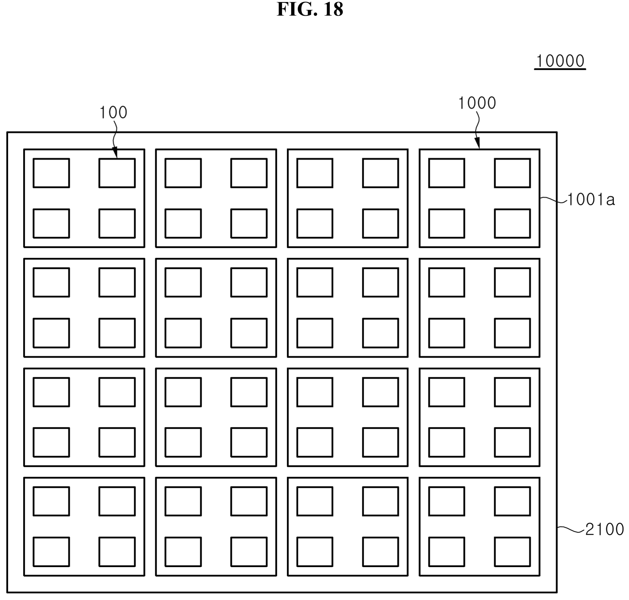

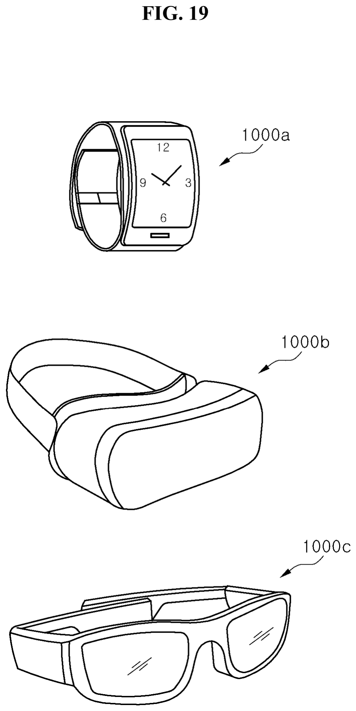

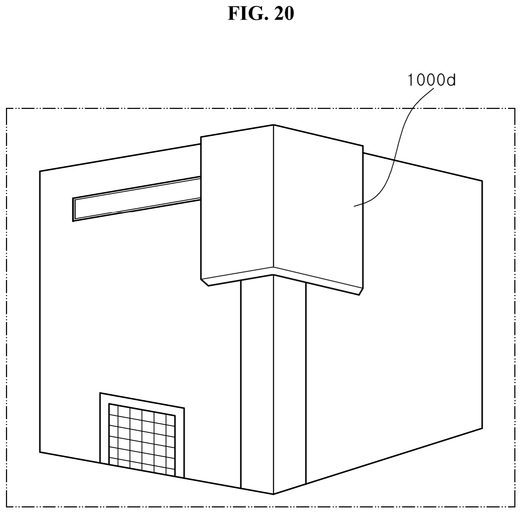

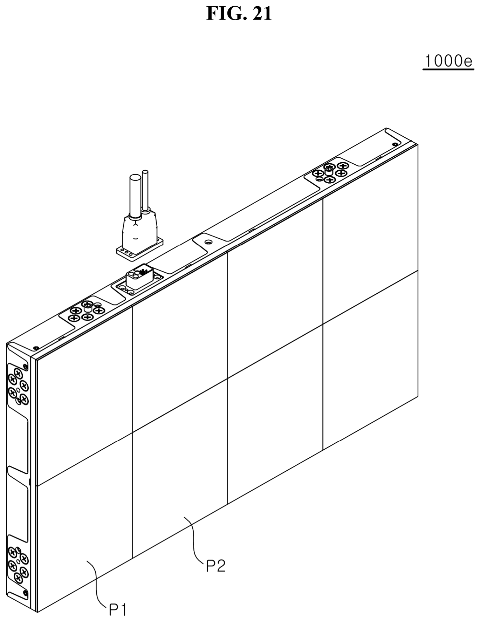

FIG. 18 is a schematic plan view illustrating a display apparatus according to an exemplary embodiment, and FIGs. 19, 20, and 21 are schematic perspective views illustrating various display apparatuses 1000a, 1000b, 1000c, 1000d, and 1000e according to an exemplary embodiment.

Referring to FIG. 18, a display apparatus 10000 may include a panel substrate 2100 and a plurality of pixel modules 1000. Herein, the pixel module 1000 is a light emitting module including a plurality of light emitting devices 100 and represents a display module.

The display apparatus 10000 is not particularly limited, but may include a smart watch 1000a, a wearable display apparatus 1000b such as a VR headset, glasses, or the like, an AR display apparatus 1000c such as augmented reality glasses, or the like, or an indoor or outdoor display apparatus 1000d and 1000e such as a micro LED TV, signage, or the like. The panel substrate 2100 and the plurality of pixel modules 1000 may be disposed within the display apparatus.

The panel substrate 2100 may include a circuit for passive matrix driving or active matrix driving. In an embodiment, the panel substrate 2100 may include interconnection lines and resistors therein, and in another embodiment, the panel substrate 2100 may include interconnections, transistors, and capacitors. The panel substrate 2100 may also have pads on its upper surface that can be electrically connected to a disposed circuit.

In an embodiment, the plurality of pixel modules 1000 is arranged on the panel substrate 2100. Each of the pixel modules 1000 may include a circuit board 1001a and a plurality of light emitting devices 100, and may include a molding member covering the light emitting devices 100.

A brightness of the smart watch 1000a may be 500~1500cd/m² (or nits) or more, and the brightness may be adjusted depending on an external illumination level. A brightness of the wearable display apparatus 1000b such as VR headsets or glasses may be 150~200 cd/m² (or nits), or a viewing angle may be 50 degrees or more. A brightness of the indoor or outdoor display apparatus 1000d and 1000e such as micro LED TV or signage may be 1000cd/m² (or nits) or more, or a viewing angle may be 80 degrees or more, and is preferable 3000 cd/m² (or nits) or more, especially for outdoor use. In the display apparatuses 1000d and 1000e, a plurality of panels P1 and P2 is arranged in rows and columns and attached to a frame, and a plurality of micro LED pixels may be arranged on the plurality of panels P1 and P2 to be lit or adjusted according to an electric supply or a signal. The plurality of panels P1 and P2 may be connected to an external power source using respective connectors, or the plurality of panels P1 and P2 may be electrically connected to one another using connectors.

Although some exemplary embodiments have been described herein, it should be understood that these exemplary embodiments are provided for illustration only and are not to be construed in any way as limiting the present disclosure. It should be understood that features or components of one exemplary embodiment can also be applied to other exemplary embodiments without departing from the spirit and scope of the present disclosure.

## Claims

1. A display module, comprising:
a circuit board;
a light emitting device disposed on the circuit board; and
a molding layer covering the light emitting device,
the light emitting device, comprising:
a first LED stack generating light of a first wavelength;
a second LED stack disposed on the first LED stack and generating light of a second wavelength; and
a third LED stack disposed on the second LED stack and generating light of a third wavelength; wherein:
each of the first, second, and third LED stacks includes a first conductivity type semiconductor layer, a second conductivity type semiconductor layer, and an active layer disposed between the first conductivity type semiconductor layer and the second conductivity type semiconductor layer, and
polarities of the first LED stack and the third LED stack disposed over and under the second LED stack are asymmetric with reference to the second LED stack.

2. The display module of claim 1,
wherein among the first and second conductivity type semiconductor layers of each of the first through third LED stacks, a thickness of a semiconductor layer disposed closer to the circuit board is smaller than that of a semiconductor layer disposed farther from the circuit board.

3. The display module of claim 1,
wherein the first and second conductivity type semiconductor layers of each of the first through third LED stacks include different types of first and second impurities, respectively, and an impurity that provides a carrier with slow mobility among the first and second impurities is disposed closer to the circuit board.

4. The display module of claim 1,
Wherein each of the first conductivity type semiconductor layers of the first through third LED stacks includes contact layers in contact with electrodes, and the contact layers have different doping concentrations from one another.

5. The display module of claim 1,
wherein among the first and second conductivity type semiconductor layers of each of the first through third LED stacks, the semiconductor layer closer to the circuit board includes a layer having a highest band gap energy.

6. The display module of claim 1,
wherein in each of the first through third LED stacks, the active layer is disposed closer to the circuit board from a center of a corresponding LED stack.

7. The display module of claim 1, wherein:
each of the first through third LED stacks has a lower surface on a circuit board side, and
distances from the lower surfaces of each of the first through third LED stacks to each active layer are different from one another.

8. The display module of claim 1, wherein:
each of the first through third LED stacks has an upper surface on an opposite side of the circuit board, and
distances from the upper surfaces of each of the first through third LED stacks to each active layer are different from one another.

9. The display module of claim 1,
wherein in each of the first through third LED stacks, the first conductivity type semiconductor layer is disposed closer to the outside of the display module than the second conductivity type semiconductor layer.

10. The display module of claim 1, wherein:
semiconductor layers facing each other of the first LED stack and the second LED stack have different polarities, and
semiconductor layers facing each other of the second LED stack and the third LED stack have different polarities.

11. The display module of claim 1,
wherein a vertical light path for light generated in the active layer of the first LED stack to escape the first LED stack is longer in an upper portion facing an opposite direction of the circuit board than in a lower portion facing the circuit board.

12. The display module of claim 1,
wherein a vertical light path for light generated in the active layer of the second LED stack to escape the second LED stack is longer in an upper portion facing the opposite direction of the circuit board than in a lower portion facing the circuit board.

13. The display module of claim 1,
wherein a vertical light path for light generated in the active layer of the third LED stack to escape the third LED stack is longer in an upper portion facing the opposite direction of the circuit board than in a lower portion facing the circuit board.

14. The display module of claim 1,
the light emitting device, further comprising:
a first insulation layer disposed on the first through third LED stacks;
a protection layer covering the first insulation layer; and
electrode pads disposed on the protection layer, wherein:
the first insulation layer has contact holes for allowing electrical connection to the first through third LED stacks,
the protection layer includes through-holes for allowing electrical connection to the first through third LED stacks, and
the electrode pads are electrically connected to the first through third LED stacks through the through-holes of the protection layer and contact holes of the first insulation layer.

15. The display module of claim 14,
wherein at least one of the electrode pads includes a depression portion in the contact hole of the first insulation layer.

16. The display module of claim 14,
wherein at least one of the through-holes of the protection layer has an asymmetric structure with respect to a line passing through a center of the through-hole.

17. The display module of claim 16,
wherein the through-holes have an inner surface close to a center of the light emitting device and an outer surface close to the outside of the light emitting device, and slopes of the inner surface and the outer surface are different from each other.

18. The display module of claim 17,
wherein a height of a highest point of the inner surface is different from that of a highest point of the outer surface.

19. The display module of claim 17,
wherein a curvature of the inner surface is different from that of the outer surface.

20. The display module of claim 14, further comprising:
a second contact electrode contacting the second conductivity type semiconductor layer of the second LED stack; and
a bridge electrode disposed on the second contact electrode,
wherein one of the electrode pads is electrically connected to the bridge electrode.
